# EUROPEAN PATENT APPLICATION

(11) **EP 4 770 271 A1**
(43) Date of publication of application: **01.07.2026**
(21) Application number: 24860221.1
(22) Date of filing: 02.08.2024
(51) Int. Cl.: H05B 6/12, H05B 6/06

(54) **INDUCTION HEATING DEVICE COMPRISING TEMPERATURE SENSOR PROVIDED IN STACKED BOARDS ON WHICH HEATING COILS ARE PRINTED**

(30) Priority: 30.08.2023 KR 20230114668; 07.03.2024 KR 20240032832
(71) Applicant: Samsung Electronics Co., Ltd., Suwon-si, Gyeonggi-do 16677 (KR)
(72) Inventor: WOO, Younghoon, Suwon-si, Gyeonggi-do 16677 (KR); KIM, Kyounghwan, Suwon-si, Gyeonggi-do 16677 (KR); JUNG, Kyunghoon, Suwon-si, Gyeonggi-do 16677 (KR); HA, Jonghun, Suwon-si Gyeonggi-do 16677 (KR)
(74) Representative: Gulde & Partner
(86) International application number: PCT/KR2024/011434
(87) International publication number: WO 2025/048300

(57) **Abstract**

Provided is an induction heating device comprising a temperature sensor provided in boards on which heating coils are patterned. The induction heating device comprises: a top plate on which a cooking container is placed; a heating coil board formed by pressing stacked boards including a plurality of heating coil pattern layers on which heating coils are printed and patterned, and an insulating layer which insulates and bonds each heating coil pattern layer to each other of the plurality of heating coil pattern layers; and a temperature sensor provided in a hole passing through the heating coil board and for sensing the temperature of the top plate or the cooking container placed on the top plate, the temperature sensor including two leads without a wire.

## Description

### Technical Field

The present disclosure relates to an induction heating device including a temperature sensor on a plurality of stacked boards having a heating coil printed thereon.

### Background Art

Various types of cooking heating appliances are used to heat food at home or in restaurants. According to the related art, gas ranges using gas as fuel are widely distributed and used, but recently, cooking heating appliances that heat an object to be heated, such as a cooking vessel, e.g., a pot, by using electricity instead of gas have become widespread.

A method of heating an object to be heated by using electricity are broadly divided into a resistance heating method and an induction heating method. The electrical resistance method is a method of heating an object to be heated (e.g., a cooking vessel) by radiating or conducting heat generated when current is passed through a metal resistance wire or a non-metallic heating element such as silicon carbide to heat the object to be heated. The induction heating method is a method of heating an object to be heated itself by generating an eddy current in the object to be heated, which is made of metal components, by using a magnetic field generated around a coil when a certain amount of high-frequency power is applied to the coil. Among these, an induction range that uses an induction heating method typically has a working coil (heating coil) in a corresponding area to heat each of a plurality of objects to be heated (cooking vessels).

The induction range is a cooking heating device that uses an induction heating principle, and is commonly called an induction device, an induction heating device, or an induction cooking device. The induction range does not consume oxygen and does not emit waste gas compared to a gas range, which can reduce indoor air pollution and prevent an increase in indoor temperature. The induction range uses an indirect method of inducing heat to the object to be heated itself, and has an advantage of high energy efficiency and stability, and low risk of burns because heat is generated only from the object to be heated and a contact surface is not heated, and accordingly, the demand for induction ranges has continuously increased recently.

Recently, induction ranges have been developed that allow an object to be heated to be placed anywhere on an upper surface (hereinafter referred to as any place). An induction range of this type can inductively heat an object to be heated regardless of the size and location of the object to be heated within an area in which multiple heating coils are present.

An induction range typically includes a heating coil wound around a copper wire and a temperature sensor that detects the temperature of a cooking vessel. However, to improve productivity, a structure in which the heating coil is printed on a board is required. In an induction range, the heating coil needs to conduct a high current, and thus when manufacturing the heating coil that is printed on the board, it is necessary to precisely design the thickness and width of a pattern, the stack thickness, and the like when the heating coil is printed. In a structure in which the heating coil is printed on the board, it is necessary to design a temperature sensor to be provided on the board on which the heating coil is printed, rather than being printed on the board.

### Disclosure of Invention

### Solution to Problem

According to an embodiment of the present disclosure, an induction heating device including a temperature sensor is provided. According to an embodiment, an induction heating device including a temperature sensor may include a plurality of heating coil pattern layers on which a top plate heating coil, on which a cooking vessel is placed, is printed and patterned, and a heating coil board generated by hot-pressing a stack board including an insulating layer that insulates and bonds between heating coil pattern layers among the plurality of heating coil pattern layers. According to an embodiment, an induction heating device including a temperature sensor may include a temperature sensor provided in a hole formed to pass through a heating coil board and configured to detect the temperature of a top plate or a cooking vessel placed on the top plate. According to an embodiment, the temperature sensor may have two leads soldered to at least a portion of the heating coil board without wires.

According to an embodiment of the present disclosure, an induction heating device including a temperature sensor is disclosed. According to an embodiment, an induction heating device including a temperature sensor may include a top plate on which a cooking vessel is placed, a plurality of heating coil pattern layers on which the top plate heating coil, on which a cooking vessel is placed, is printed and patterned, and a heating coil board generated by hot-pressing a stack board including an insulating layer that insulates and bonds between heating coil pattern layers among the plurality of heating coil pattern layers. According to an embodiment, an induction heating device including a temperature sensor may include a temperature sensor provided in a hole provided in a heating coil board and configured to detect the temperature of a top plate or a cooking vessel placed on the top plate. According to an embodiment, the temperature sensor may be electrically connected to a female connector with two leads soldered to at least one board of the heating coil board without wires.

### Brief Description of Drawings

FIG. 1A is a diagram for describing an induction heating device according to an embodiment of the present disclosure.
FIG. 1B is a diagram for describing an induction heating device according to an embodiment of the present disclosure.
FIG. 2 is a cross-sectional view of a cooking vessel placed on an induction heating device according to an embodiment of the present disclosure.
FIG. 3 is an inverter circuit diagram of an induction heating device for operating a plurality of heating coils according to an embodiment of the present disclosure.
FIG. 4 illustrates an induction heating device using a quadrilateral heating coil according to an embodiment of the present disclosure.
FIG. 5 is a diagram showing an induction heating device together with a heating coil according to an embodiment of the present disclosure.
FIG. 6 is a diagram showing a heating coil being wound in an any place induction heating device.
FIG. 7A is a diagram showing an outer appearance of a wound heating coil.
FIG. 7B is an example diagram showing an induction heating device in which a temperature sensor with a wire is mounted.
FIG. 7C is an example diagram showing a temperature sensor with a wire mounted in a heating coil.
FIG. 8 illustrates a heating coil board of an induction heating device according to an embodiment of the present disclosure.
FIG. 9A is a plan view of a heating coil board according to an embodiment of the present disclosure.
FIG. 9B is a cross-sectional view showing interlayer connection of a heating coil board according to an embodiment of the present disclosure.
FIG. 9C is a cross-sectional view of a series-parallel connection between a 16-layer heating coil board and a heating coil board according to an embodiment of the present disclosure.
FIG. 9D is a cross-sectional view showing interlayer connection of a heating coil board including a hole for a temperature sensor according to an embodiment of the present disclosure.
FIG. 9E is a cross-sectional view showing interlayer connection of a heating coil board including a hole for a temperature sensor according to an embodiment of the present disclosure.
FIG. 10A is a diagram showing a temperature sensor mounted on a heating coil board according to an embodiment of the present disclosure.
FIG. 10B is a cross-sectional view showing a temperature sensor mounted on an induction heating device according to an embodiment of the present disclosure.
FIG. 11A is a diagram showing a temperature sensor mounted on a heating coil board according to an embodiment of the present disclosure.
FIG. 11B is a cross-sectional view showing a temperature sensor mounted on an induction heating device according to an embodiment of the present disclosure.
FIG. 12A is a diagram showing a temperature sensor mounted on a heating coil board according to an embodiment of the present disclosure.
FIG. 12B is a cross-sectional view showing a temperature sensor mounted on an induction heating device according to an embodiment of the present disclosure.
FIG. 13A is a diagram showing a temperature sensor mounted on a heating coil board according to an embodiment of the present disclosure.
FIG. 13B is a cross-sectional view showing a temperature sensor mounted on a rear surface of a heating coil board according to an embodiment of the present disclosure.
FIG. 14 illustrates a process of manufacturing a heating coil board of an induction heating device according to an embodiment of the present disclosure.
FIG. 15A is a diagram illustrating a heating coil board layer by layer according to an embodiment of the present disclosure.
FIG. 15B is a diagram illustrating a heating coil board layer by layer according to an embodiment of the present disclosure.
FIG. 16 is a diagram showing a heating coil pattern width specification according to an embodiment of the present disclosure.
FIG. 17 is a diagram showing a cross section of a stack board according to an embodiment of the present disclosure.
FIG. 18 illustrates a structure in which each board of an induction heating device is connected according to an embodiment of the present disclosure.
FIG. 19 is a sequence diagram for determining empty heating of a cooking vessel according to an embodiment of the present disclosure.
FIG. 20 is a sequence diagram for controlling an induction heating device based on overheating of a cooking vessel according to an embodiment of the present disclosure.
FIG. 21 is a flowchart of generating a heating coil board including a temperature sensor according to an embodiment of the present disclosure.
FIG. 22 is a block diagram of an induction heating device according to an embodiment of the present disclosure.

### Mode for the Invention

The terms used in the present disclosure will be briefly described, and an embodiment of the present disclosure will be described in detail.

The terms used in the present disclosure are selected from the most widely used general terms possible while considering the functions of the present disclosure, but may vary depending on the intention of engineers in the field, precedents, the emergence of new technologies, and the like. In certain cases, there are terms arbitrarily selected by the applicant, and in such cases, their meanings are described in detail in the corresponding description of an embodiment of the present disclosure. Therefore, the terms used in the present disclosure need to be defined based on the meaning of the terms and the overall content of the present disclosure, rather than simply the names of the terms.

In the present disclosure, the expression "at least one of a, b or c" may refer to "a", "b", "c", "a and b", "a and c", "b and c", "all of a, b and c", or variations thereof.

Throughout the present disclosure, unless explicitly described to the contrary, the word "comprise (include)" and variations such as "comprises (includes)" or "comprising (including)", will be understood to imply the inclusion of stated elements but not the exclusion of any other elements. The terms such as "...unit" or "module" disclosed in the present disclosure mean units for processing at least one function or operation, which may be implemented by hardware, software, or a combination thereof.

Hereinafter, embodiments of the present disclosure are described in detail such that those of skill in the art may easily implement the same with reference to the accompanying drawings. However, an embodiment of the present disclosure may be implemented in various different forms and is not limited to the embodiments described herein. To clearly explain an embodiment of the present disclosure in the drawings, portions that are not related to explanation are omitted, and similar portions are given similar drawing reference numerals throughout the present disclosure.

To heat a cooking vessel, an induction heating device heats the cooking vessel by inducing a magnetic field in a heating coil and causing an eddy current to flow through the cooking vessel. In this case, when the heating coil and a vessel detection coil that detects the cooking vessel are made to a printed circuit board (PCB), assembly becomes easier and the durability of the induction heating device increases. However, when the heating coil is patterned to form a plurality of pattern layers, insulation also needs to be designed appropriately. A temperature sensor for detecting the temperature of a cooking vessel heated by an induction heating device needs to be disposed on a board having a patterned heating coil with high durability and easy assembly.

Therefore, according to an embodiment of the present disclosure, an induction heating device including a plurality of heating coil pattern layers and a temperature sensor provided on the heating coil pattern layers is provided. In the present disclosure, a board may be a printed circuit board (PCB) on which a patterned circuit is printed. When the plurality of heating coil pattern layers are stacked, an insulating layer may be provided therebetween, and the temperature sensor may be provided in the heating coil pattern layers.

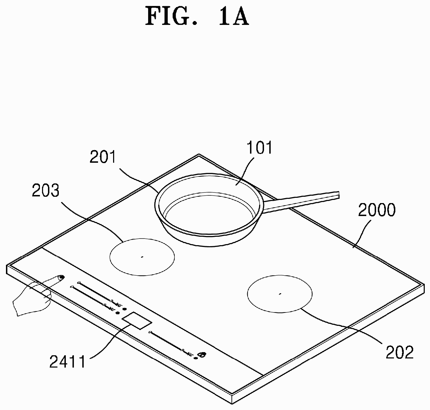

FIG. 1A is a diagram for describing an induction heating device according to an embodiment of the present disclosure.

Referring to FIG. 1A, an induction heating device 2000 according to an embodiment of the present disclosure may include a plurality of burners 201, 202, and 203. Hereinafter, the induction heating device 2000 may be expressed as an induction heating device, an induction cooking device, or simply a heating device. Not all of components illustrated in FIG. 1A are required. The induction heating device 2000 may be implemented with more components or may be implemented with fewer components than the illustrated components.

A cooking vessel 101 may be a device that heats contents inside the cooking vessel 101. The contents of the cooking vessel 101 may be liquids such as water, tea, coffee, soup, juice, wine, and oil, or solids such as butter, meat, vegetables, bread, and rice, but are not limited thereto.

According to an embodiment of the present disclosure, the cooking vessel 101 may wirelessly receive power from the induction heating device 2000 by using electromagnetic induction. Accordingly, the cooking vessel 101 according to an embodiment of the present disclosure may not include a power cord connected to a power outlet.

According to an embodiment of the present disclosure, the type of cooking vessel 101 that wirelessly receives power from the induction heating device 2000 may vary. The cooking vessel 101 may be a general induction heating (IH) vessel (hereinafter, **IH** vessel) including a magnetic material. The cooking vessel 101 may induce a magnetic field in the vessel (IH metal) itself.

The cooking vessel 101 may be a general IH vessel such as a pot, a frying pan, or a steamer. The cooking vessel 101 may include a cooker device. The cooker device may be a device into which a typical IH vessel is to be inserted or removed. According to an embodiment, the cooker device may be a device capable of automatically cooking contents according to a recipe. Depending on its purpose, the cooker device may be called a pot, a rice cooker, or a steamer. For example, when a cooker device has an inner pot inserted thereinto for cooking rice, the cooker device may be called a rice cooker. Hereinafter, the cooker device may be defined as a smart pot.

According to an embodiment of the present disclosure, when the cooking vessel 101 includes a communication interface, the cooking vessel 101 may communicate with the induction heating device 2000. The communication interface may include a short-range wireless communication interface and a long-range wireless communication interface. The short-range wireless communication interface may include, but is not limited to, a Bluetooth communication unit, a Bluetooth low energy (BLE) communication unit, a near field communication interface (NFC), a WLAN (Wi-Fi) communication unit, a Zigbee communication unit, an infrared data association (IrDA) communication unit, a Wi-Fi direct (WFD) communication unit, an ultra wideband (UWB) communication unit, and an Ant+ communication unit. The long-range wireless communication interface may be used to communicate with a server (not shown) when the cooking vessel 101 is remotely controlled by a server in an Internet of Things (IoT) environment. The long-range wireless communication interface may include the Internet, a computer network (e.g., LAN or WAN), and a mobile communication unit. The mobile communication unit may include, but is not limited to, a 3G module, a 4G module, a 5G module, an LTE module, an NB-IoT module, and an LTE-M module.

According to an embodiment of the present disclosure, the cooking vessel 101 may transmit information to a server (not shown) through the induction heating device 2000. For example, the cooking vessel 101 may transmit information obtained from the cooking vessel 101 (e.g., temperature information of the contents) to the induction heating device 2000 through short-range wireless communication (e.g., Bluetooth or BLE). In this case, the induction heating device 2000 may transmit information obtained from the cooking vessel 101 to the server by connecting to the server by using a WLAN (Wi-Fi) communication unit or a long-range wireless communication interface (e.g., the Internet). The server may provide information obtained from the cooking vessel 101 received from the induction heating device 2000 to a user through a mobile terminal (not shown) connected to the server. According to another embodiment of the present disclosure, the induction heating device 2000 may directly transmit information obtained from the cooking vessel 101 to the mobile terminal of the user through device to device (D2D) communication (e.g., Wi-Fi direct (WFD) communication or BLE communication).

According to an embodiment of the present disclosure, the cooking vessel 101 may directly transmit information of the cooking vessel 101 (e.g., temperature information of the contents) to the server through a communication interface (e.g., WLAN (Wi-Fi) communication unit). The cooking vessel 101 may directly transmit information obtained from the cooking vessel 101 (e.g., temperature information of the contents) to the mobile terminal of the user through short-range wireless communication (e.g., Bluetooth and BLE) or device to device (D2D) communication.

The induction heating device 2000 according to an embodiment of the present disclosure may be a device that wirelessly transmits power to the cooking vessel 101 located on a top plate of the induction heating device 2000 by using electromagnetic induction. The induction heating device 2000 may include a working coil that generates a magnetic field for inductively heating the cooking vessel 101. The working coil is a coil for forming a magnetic field through an electric flow and may be referred to as a heating coil throughout the present disclosure.

Generating a magnetic field by a heating coil may include transmitting power by using a magnetic field induced in an IH metal (e.g., iron) by magnetic induction. For example, the induction heating device 2000 may generate an eddy current in the cooking vessel 101 by flowing a current through a heating coil to form a magnetic field.

According to an embodiment of the present disclosure, the induction heating device 2000 may include a plurality of heating coils. For example, when the top plate of the induction heating device 2000 includes a plurality of cooking zones, the induction heating device 2000 may include a plurality of heating coils corresponding to each of the plurality of cooking zones. The induction heating device 2000 may include a high-power cooking zone in which a first heating coil is provided at an inner side and a second heating coil is provided at an outer side. The high-power cooking zone may include two or more heating coils.

The top plate of the induction heating device 2000 according to an embodiment of the present disclosure may include reinforced glass such as ceramic glass not to be easily broken. The top plate of the induction heating device 2000 may include a guide mark to guide the cooking zone in which the cooking vessel 101 needs to be placed.

The induction heating device 2000 according to an embodiment of the present disclosure may detect that the cooking vessel 101 including a magnetic material is placed on a top plate. For example, the induction heating device 2000 may detect that the cooking vessel 101 is placed on the top plate of the induction heating device 2000 based on a change in a current value (inductance) of the heating coil due to approach of the cooking vessel 101. A vessel detection coil of the induction heating device 2000 may detect when the cooking vessel 101 is placed on the top plate.

The induction heating device 2000 according to an embodiment of the present disclosure may detect the temperature of the cooking vessel 101 when the cooking vessel 101 is placed on the top plate and is cooked. For example, the induction heating device 2000 may detect the temperature of the cooking vessel 101 through a temperature sensor. When empty heating is performed on the cooking vessel 101 without any contents in the cooking vessel 101, the induction heating device 2000 may detect that empty heating is performed on the cooking vessel 101 through the temperature sensor, thereby preventing overheating of the cooking vessel 101 and the induction heating device 2000. The induction heating device 2000 according to an embodiment of the present disclosure may detect, through the temperature sensor, that a cooking zone is heated by a heating coil even when the cooking vessel 101 is not placed on the top plate. The induction heating device 2000 may detect an operation of the heating coil even without the cooking vessel 101 through a vessel detection coil or vessel detection sensor, but may also detect the operation of the heating coil through the temperature sensor. When the induction heating device 2000 performs a heating operation without the cooking vessel 101, the temperature of the top plate may be detected through the temperature sensor to prevent overheating of the induction heating device 2000.

According to an embodiment of the present disclosure, the induction heating device 2000 may include a communication interface for communicating with an external device. For example, the induction heating device 2000 may communicate with the cooking vessel 101 or a server through a communication interface. The communication interface may include a short-range wireless communication interface (e.g., NFC communication unit, Bluetooth communication unit, and BLE communication unit), and a mobile communication unit.

According to an embodiment of the present disclosure, the induction heating device 2000 may detect the cooking vessel 101 placed on the top plate through the communication interface. For example, the induction heating device 2000 may detect the cooking vessel 101 by receiving a packet transmitted from the cooking vessel 101 placed on the top plate by using short-range wireless communication (e.g., BLE mesh network and Bluetooth).

According to an embodiment of the present disclosure, the induction heating device 2000 may detect whether the cooking vessel 101 is placed on the top plate of the induction heating device 2000 through the vessel detection coil even if the cooking vessel 101 does not have a communication interface.

According to an embodiment of the present disclosure, the induction heating device 2000 may display information related to the cooking vessel 101 through a user interface. For example, when the cooking vessel 101 is detected, the induction heating device 2000 may display information such as identification information of the cooking vessel 101, location information of the cooking vessel 101, presence or absence of the cooking vessel 101, and material of the cooking vessel 101 on a display provided in the user interface.

Referring to FIG. 1A, when a user places the cooking vessel 101 (e.g., a pot) on the top plate of the induction heating device 2000, the induction heating device 2000 may provide the user with identification information of the cooking vessel 101 (e.g., a pot), location information of the cooking vessel 101 (e.g., located on the right burner), and material information of the cooking vessel 101 on a display 2411 as an output interface. The material information of the cooking vessel 101 may be detected by a change in inductance when the cooking vessel 101 is placed on the top plate and heated, and the material information of the cooking vessel 101 may be information related to a degree to which the cooking vessel 101 is heated when the same heating power is applied. For example, when the cooking vessel 101 includes material A, the cooking vessel 101 may boil 1 liter of water to 100 degrees Celsius in 1 minute when heating power is 1.5 kW, whereas when the cooking vessel 101 includes material B, the cooking vessel 101 may boil 1 liter of water to 100 degrees Celsius in 2 minutes when the heating power is 1.5 kW. The induction heating device 2000 displays the materials by grade, for example, grades 1 to 7, on a display such that a consumer may easily determine whether the cooking vessel 101 currently owned by the consumer includes a material with high heating efficiency.

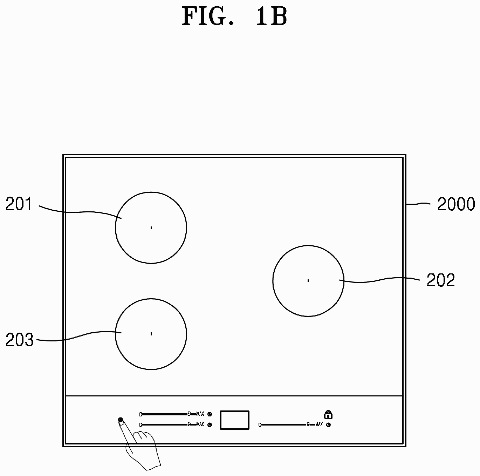

FIG. 1B is a diagram for describing an induction heating device according to an embodiment of the present disclosure.

FIG. 1B is a perspective view of the induction heating device 2000 illustrated in FIG. 1A as viewed in a state in which no cooking vessel is placed thereon. The induction heating device 2000 illustrated in FIG. 1B may include the plurality of burners 201, 202, and 203, and thus may heat a plurality of cooking vessels simultaneously. When the induction heating device 2000 heats the plurality of cooking vessels simultaneously, the heating coil corresponding to each burner may operate. The induction heating device 2000 illustrated in FIGS. 1A and 1B is an induction heating device in which a burner corresponding to a cooking vessel is set.

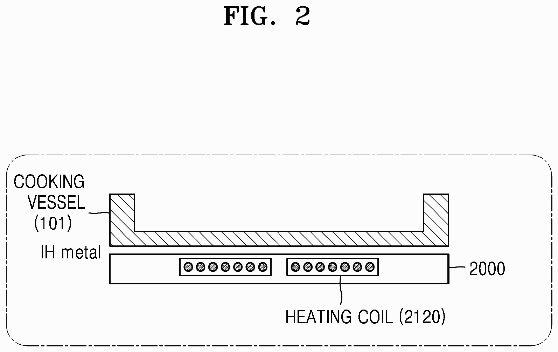

FIG. 2 is a cross-sectional view of a cooking vessel placed on an induction heating device according to an embodiment of the present disclosure.

Referring to FIG. 2, the cooking vessel 101 may include a magnetic material (e.g., **IH** metal) in which a magnetic field is to be induced.

The cooking vessel 101 may be inductively heated by the induction heating device 2000 and may be a vessel of various shapes including a magnetic material. Induction heating (IH) is a method of heating an IH metal by using a electromagnetic induction phenomenon. For example, when an alternating current (AC) is supplied to a heating coil 2120 of the induction heating device 2000, a time-varying magnetic field is induced inside the heating coil 2120. The magnetic field generated by the heating coil 2120 passes through a lower surface of the cooking vessel 101. When a time-varying magnetic field passes through an IH metal (e.g., iron, steel, nickel, or various types of alloys) provided in the lower surface of the cooking vessel 101, a current that rotates around the magnetic field is generated in the IH metal. This rotating current is called an eddy current, and a phenomenon in which a current is induced by a time-varying magnetic field is called an electromagnetic induction phenomenon. Heat is generated at the lower surface of the cooking vessel 101 by an eddy current and the resistance of the **IH** metal (e.g., iron). The contents of the cooking vessel 101 may be heated by the heat generated in this case.

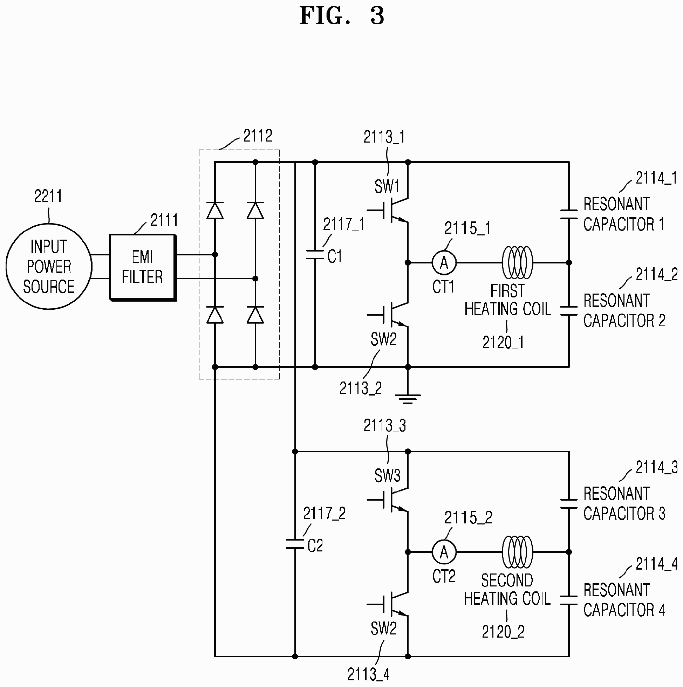

FIG. 3 is an inverter circuit diagram of an induction heating device for operating a plurality of heating coils according to an embodiment of the present disclosure.

Referring to FIG. 3, an input power source 2211 is an AC power source. An AC voltage of the input power source 2211 passes through an electro magnetic interference (EMI) filter 2111 and is rectified by a rectifier circuit 2112. A diode may be used as the rectifier circuit 2112 as a component for converting the AC voltage into a direct current (DC) voltage. A device of the rectifier circuit 2112 may be a diode, but a thyristor or other types of switching devices may also be used. When the AC voltage is converted into the DC voltage through the rectifier circuit 2112, the DC voltage may be smoothed by DC link capacitors 2117_1 and 2117_2.

FIG. 3 illustrates two resonance circuits assuming that there are two heating coils 2120_1 and 2120_2, but when there are three burners and three heating coils are required, a resonance circuit may be added.

The DC voltage smoothed by the DC link capacitor 2117_1 generates a magnetic field in a first heating coil 2120_1 through resonance between the first heating coil 2120_1 and a resonance capacitor 1 2114_1 or resonance between the first heating coil 2120_1 and a resonance capacitor 2 2114_2 by a switching operation of the two switch devices SW1 2113_1 and SW2 2113_2. The magnetic field generated in the first heating coil 2120_1 generates an eddy current in the cooking vessel placed above the first heating coil 2120_1, thereby heating the contents of the cooking vessel. A CT1 2115_1 is a current sensor configured to detect a current flowing in the first heating coil 2120_1.

Similarly, the DC voltage smoothed by the DC link capacitor 2117_2 at a lower end generates a magnetic field in a second heating coil 2120_2 through resonance between the second heating coil 2120_2 and a resonance capacitor 3 2114_3 or resonance between the second heating coil 2120_2 and a resonance capacitor 4 2114_4 by a switching operation of the two switch devices SW3 2113_3 and SW4 2113_4. The magnetic field generated in the second heating coil 2120_2 generates an eddy current in the cooking vessel placed above the second heating coil 2120_2, thereby heating the contents of the cooking vessel. A CT2 2115_2 is a current sensor configured to detect a current flowing in the second heating coil 2120_2.

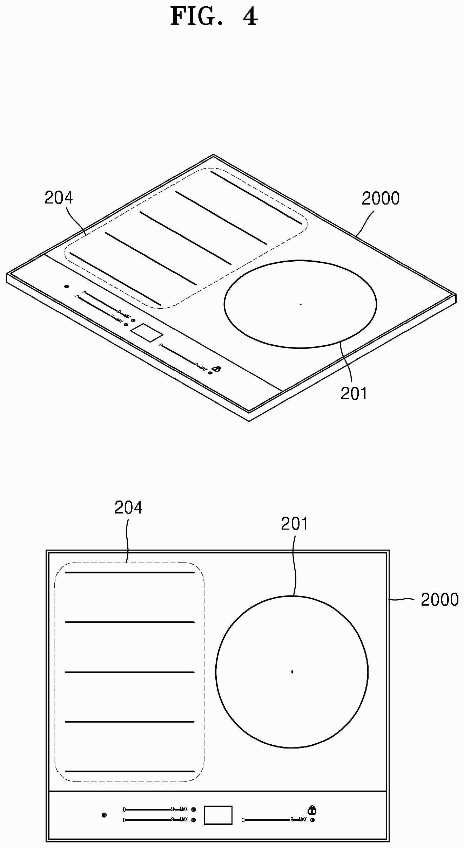

FIG. 4 illustrates an induction heating device using a quadrilateral heating coil according to an embodiment of the present disclosure.

Referring to FIG. 4, the induction heating device 2000 according to an embodiment of the present disclosure may include a circular first burner 201 operated by a circular heating coil and a quadrilateral burner 204 formed by a quadrilateral heating coil. The quadrilateral shape may be rectangular, and the heating coil on a lower surface of the quadrilateral burner 204 may include a plurality of rectangular heating coils. "The quadrilateral heating coil" may be understood not to mean that the wound shape of the heating coil forms a perfect quadrilateral with exact corner angles, but rather that the heating coil has an overall quadrilateral shape or a shape substantially similar to a quadrilateral. This is because, during the winding or printing of the heating coil, the corner portions rarely form precise angles. Alternatively, a plurality of circular heating coils may be used as the heating coil on the lower surface of the quadrilateral burner 204.

When a quadrilateral heating coil is used in the induction heating device 2000, for example, when a quadrilateral pot is placed thereon, there is no non-cooking zone. Even when a user of the induction heating device 2000 places the cooking vessel at any position within the quadrilateral burner 204, the induction heating device 2000 may recognize the cooking vessel and operate the quadrilateral heating coil required to heat the cooking vessel to heat the contents of the cooking vessel. Although FIG. 4 illustrates a case in which the first burner 201, which is a circular burner, and the quadrilateral burner 204 are present together, the induction heating device 2000 according to an embodiment of the present disclosure may include only a quadrilateral burner. In this case, the induction heating device 2000 detects the cooking vessel and operates the heating coil even when the cooking vessel is placed at any position, and thus is called an any place induction heating device.

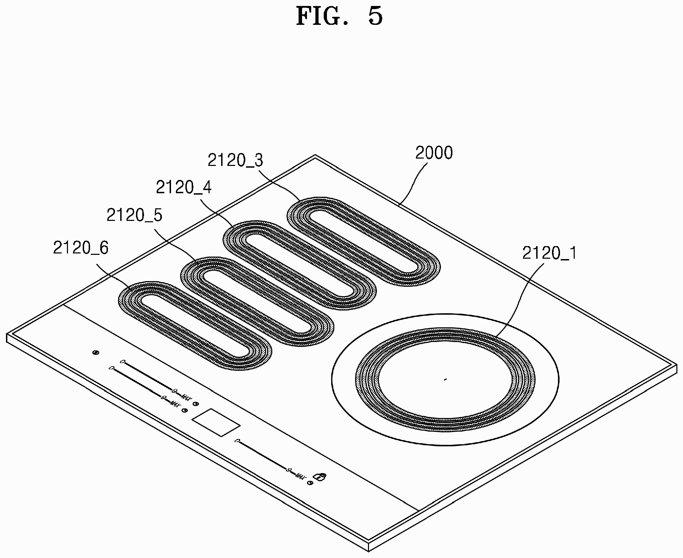

FIG. 5 is a diagram showing an induction heating device together with a heating coil according to an embodiment of the present disclosure.

FIG. 5 shows a state in which heating coils inside the induction heating device 2000 are wound based on an outer appearance of the induction heating device 2000. The coiled shape of the heating coil is not actually visible from the outside. As shown in FIG. 5, according to an embodiment, four quadrilateral heating coils 2120_3, 2120_4, 2120_5, and 2120_6 corresponding to the quadrilateral burner 204 in the induction heating device 2000 are wound sequentially from the top of the induction heating device 2000. This is merely one example, and the number of quadrilateral heating coils 2120_3, 2120_4, 2120_5, and 2120_6 corresponding to the quadrilateral burner 204 may be four or more or may be less than four. When the induction heating device 2000 is an any place induction heating device as described above, the first heating coil 2120_1 may also be replaced by one or more quadrilateral heating coils.

On a right side of the top plate of the induction heating device 2000 illustrated in FIG. 5, the circular first heating coil 2120_1 corresponding to the circular first burner 201 is wound, as seen in FIG. 1.

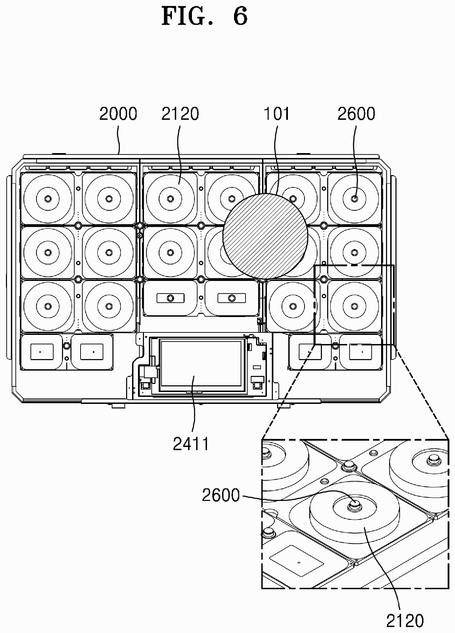

FIG. 6 is a diagram showing a heating coil being wound in an any place induction heating device.

As shown in FIG. 6, the heating coil 2120 of the induction heating device 2000 is manufactured by winding the Litz wire in a round shape and densely arranged below the top plate of the induction heating device 2000, and thus there is no heating gap regardless of the position of the cooking vessel 101. The induction heating device 2000 illustrated in FIG. 6 may be called an any place induction heating device. In the induction heating device illustrated in FIG. 6, heating coils are arranged densely such that there are no blind spots between the plurality of heating coils. At least one vessel detection coil may also be placed at a position in which the heating coil is disposed.

According to an embodiment, a temperature sensor 2600 may be located together with each heating coil 2120 to sense the temperature of the cooking vessel 101. The temperature sensor 2600 may not necessarily have to be located in the center of the heating coil 2120, but the temperature sensor 2600 may be located in the center of the heating coil 2120 to efficiently detect the temperature of the cooking vessel 101.

When heating coils are densely arranged on an induction heating device 2000 as shown in FIG. 6, vessel detection coils may also be densely arranged, and a plurality of vessel detection coils may detect whether the cooking vessel 101 is present and, if present, a position in which the cooking vessel 101 is placed on the top plate of the induction heating device 2000 based on a change in current on the vessel detection coils. For example, in FIG. 6, a value of current flowing in a vessel detection coil below the position in which the cooking vessel 101 is placed may be different from a current value flowing in a vessel detection coil in other positions in which the cooking vessel 101 is not placed. Based on a difference in these current values, the induction heating device 2000 may first detect presence of the cooking vessel 101 and also know the position of the cooking vessel 101. When the position of the cooking vessel 101 is determined, the induction heating device 2000 may use only the heating coil below the cooking vessel 101 for heating.

The induction heating device 2000 according to an embodiment of the present disclosure may detect the temperature of the cooking vessel 101 through the temperature sensor 2600. The temperature sensor 2600 may detect that empty heating is performed on the cooking vessel 101 through the temperature detected when empty heating is performed on the cooking vessel 101 without any contents in the cooking vessel 101. A processor of the induction heating device 2000 may determine that empty heating is performed on the cooking vessel 101 based on a temperature through the temperature sensor 2600 and a temperature change over time. The induction heating device 2000 according to an embodiment of the present disclosure may detect, through the temperature sensor 2600, that a cooking zone is heated by a heating coil even when the cooking vessel 101 is not placed on the top plate. When the induction heating device 2000 performs a heating operation without the cooking vessel 101, the temperature of the top plate may be detected through the temperature sensor 2600 to prevent overheating of the induction heating device 2000.

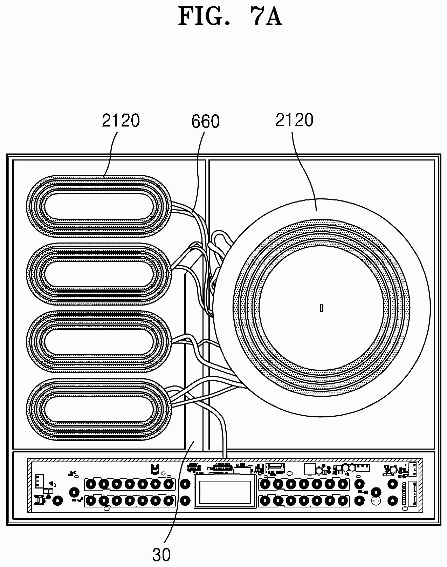

FIG. 7A is a diagram showing an outer appearance of a wound heating coil.

Referring to FIG. 7A, the heating coil 2120 is illustrated to be connected to an inverter board 30 via a wire 660. The inverter board 30 may include an inverter connector to which the wire 660 is to be connected. The heating coil 2120 may be manufactured by winding the Litz wire into a round shape, or in the case of the quadrilateral heating coils 2120_3, 2120_4, 2120_5, and 2120_6, into a quadrilateral shape. The Litz wire may be used as a conductor wire. A copper wire is widely used as the Litz wire. An end of each heating coil 2120 may be connected to the inverter board 30 via the wire 660. When all heating coils 2120 are manufactured with the Litz wire, there may be blind spots between the plurality of heating coils in the any place induction heating device in which the cooking vessel 101 is to be freely placed anywhere on the top plate, and thus it is necessary to manufacture each heating coil with a small size and place the heating coils densely together. When the heating coil 2120 is manufactured with the Litz wire, the Litz wire needs to be wound manually or through a semi-automatic operation, and thus a work process takes a lot of time and there is also a possibility that a heating coil product may not be consistent. If the heating coil product is not constant, the inductance determined by the heating coil may result in an inconsistent result. When a heating coil made of a Litz wire is used, as shown in FIG. 7A, numerous wires 660 connected to the heating coil 2120 and the inverter board 30 need to be used, which not only complicates the work process but also makes the assembly process inefficient and increases the manufacturing cost. Wire damage may occur when long wires become tangled with each other. This phenomenon may cause poor wire quality and poor quality of the induction heating device 2000.

Recently, the induction heating device 2000 and the components provided in the induction heating device 2000 have become increasingly smaller, slimmer, and thinner, and according to this trend, issues have also arisen regarding reducing heat generated from circuit components. Various cooling structures have been developed to address the heat generated from circuit components, but as the number of heating coils increases, connection between circuit components become more complex, and a space for arranging the heating coils, wires connected to the heating coils, and an inverter board becomes narrower, making it difficult to design a circuit component and a cooling structure.

Therefore, to resolve this, a plurality of heating coils of the induction heating device 2000 according to an embodiment of the present disclosure may be manufactured by printing the coils on a heating coil board rather than by winding the coils with the Litz wire. A stack board in which a plurality of heating coil pattern layers with printed heating coils are stacked may be hot-pressed to generate a heating coil board. The stack board may include an insulating material for insulation along with each heating coil pattern layer including printed heating coils.

The heating coil board generated as such may be connected to the inverter board 30 via the wire 660, but a board-to-board connection method may be used in which boards are connected with fixed vertical connectors mounted on each board. According to an embodiment of the present disclosure, the heating coil board may be connected to the inverter board or intermediate board via a connector.

The heating coil 2120 printed within the heating coil board resonates with a resonance capacitor (not shown) on the inverter board 30 by driving the inverter, thereby heating the cooking vessel 101. The inverter board 30 may also be referred to as an inverter printed board assembly (PBA).

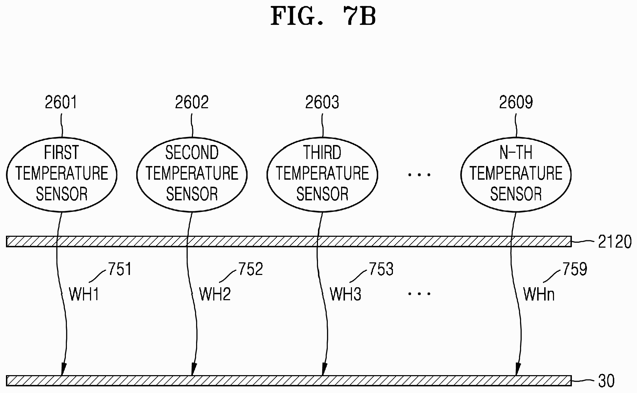

FIG. 7B is an example diagram showing an induction heating device in which a temperature sensor is mounted.

A plurality of temperature sensors may be mounted in the induction heating device 2000. When the induction heating device 2000 includes a circular heating coil, at least one temperature sensor may be mounted on each circular heating coil. When the induction heating device 2000 is an any place induction heating device, a plurality of temperature sensors may be installed at positions in which the cooking vessel 101 is to be placed.

Referring to FIG. 7B, the temperature sensor may include a first temperature sensor 2601, a second temperature sensor 2602, a third temperature sensor 2603, ..., and an n-th temperature sensor 2609 (n is a natural number greater than 3). The first temperature sensor 2601, the second temperature sensor 2602, ..., and the n-th temperature sensor 2609 may be mounted on the heating coil 2120. The first temperature sensor 2601, the second temperature sensor 2602, ..., and the n-th temperature sensor 2609 may be connected to the inverter board 30 via a wire. In other words, the first temperature sensor 2601 may be connected to the inverter board 30 via a first wire 751, the second temperature sensor 2602 may be connected to the inverter board 30 via a second wire 752, the third temperature sensor 2603 may be connected to the inverter board 30 via a third wire, ..., and the n-th temperature sensor 2609 may be connected to the inverter board 30 via an n-th wire 759.

However, when each temperature sensor is connected to the inverter board 30 via a wire as in FIG. 7b, an assembly process becomes complicated, which increases the cost and increases a defect rate due to tangled wires, which may also affect the durability of the induction heating device 2000.

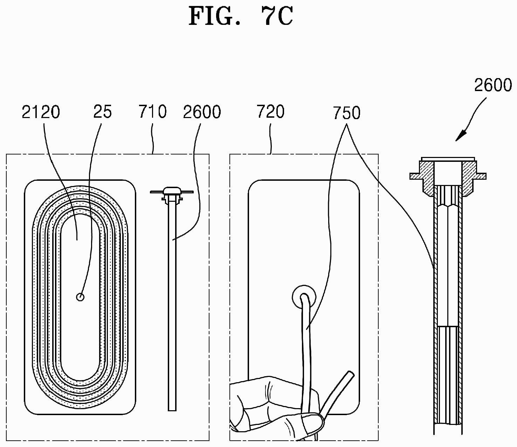

FIG. 7C is an example diagram showing a temperature sensor mounted in a heating coil.

Referring to FIG. 7C, a heating coil front portion 710 includes the heating coil 2120 and a hole in which the temperature sensor 2600 is to be mounted. The temperature sensor 2600 may be mounted to pass through the hole. A wire 750 provided in the temperature sensor 2600 serves as device for electrical connection with the inverter board 30 installed at a lower portion of the induction heating device 2000.

The wire 750 of the temperature sensor 2600 is shown to extend from a heating coil rear portion 720. A structure in which a plurality of wires 750 of the temperature sensor 2600 extend below the heating coil 2120 may complicate the assembly process and may also cause failure such as wire tangling. Therefore, first, to simplify the assembly process, the heating coil 2120 of the induction heating device 2000 is printed and patterned on a PCB, and together with the patterned heating coil board, a temperature sensor coupling structure that simplifies the assembly process is required.

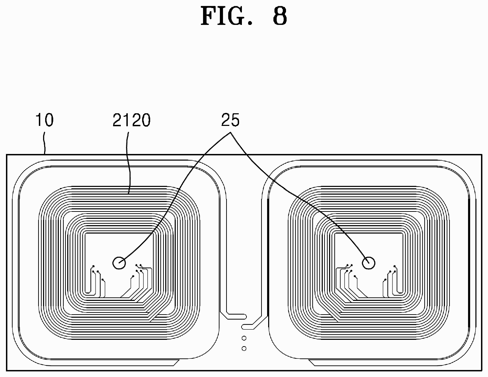

FIG. 8 illustrates a heating coil board of an induction heating device according to an embodiment of the present disclosure.

Referring to FIG. 8, a heating coil board 10 on which the heating coil 2120 is patterned on a board is illustrated.

The heating coil may be provided in the form of a conductor printed on the heating coil board 10. According to an embodiment, the heating coil board 10 on which two or more heating coil pattern layers are stacked may be employed as the heating coil board 10. To implement a high power (maximum power exceeds 3 kW) induction heating device using the heating coil board 10 in two or more heating coil pattern layers are stacked, the thickness of a first copper layer (thickness of a coil pattern) needs to be about 500 µm. As such, the influence of a skin effect may increase, which increases coil loss. To implement high power while reducing the skin effect, a method of reducing the thickness and width of the heating coil pattern and ensuring current capacity by connecting a plurality of heating coil patterns in parallel may be considered. In this case, the number of interlayer connections for connecting the plurality of heating coils in parallel increases, and heating coil loss according to a wiring length may also increase. Accordingly, according to an embodiment of the present disclosure, a stack board including multilayer heating coil pattern layers for reducing the number of interlayer connections while reducing heating coil loss and the heating coil board 10 obtained by hot-pressing the stack board may be employed. Here, the multilayer may include 4 or more layers. According to an embodiment, a pattern layer of the heating coil 2120 may be provided in a sheet shape on the heating coil board 10. For example, the heating coil 2120 may be in the form of a printed circuit board formed through a patterning process using photoresist or the like on the heating coil board 10. According to an embodiment, the plurality of heating coils may have the same shape and size. The shape and size of the plurality of heating coils need not all be the same. For example, at least one of the plurality of heating coils may have at least one different shape and size from the other heating coils.

The heating coil board 10 may replace positions of a plurality of heating coil provided in the induction heating device 2000 illustrated in FIG. 6. In this way, the any place induction heating device 2000 including the heating coil board 10 may be manufactured.

The heating coil board 10 may include a hole 25 for the temperature sensor 2600. In FIG. 8, the hole 25 for the temperature sensor 2600 is located in the center of the heating coil pattern, but the position of the hole 25 for the temperature sensor 2600 may be located anywhere as long as the temperature sensor 2600 detects the cooking vessel 101.

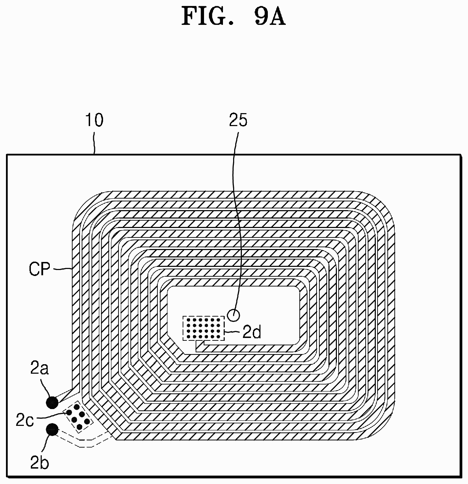

FIG. 9A is a plan view of a heating coil board according to an embodiment of the present disclosure.

Referring to FIG. 9A, the heating coil board 10 may be a print circuit board formed by stacking four or more heating coil pattern layers PL on which a coil pattern CP is formed. The heating coil board 10 may include the hole 25 for the temperature sensor 2600. According to an embodiment, the hole 25 may be a hole formed to pass through the entire heating coil board 10. According to an embodiment, the hole 25 may be inserted into only some layers of the stacked portion of the heating coil board 10 such that a lead wire of the temperature sensor 2600 may be soldered to at least one board (layer) provided in the heating coil board 10. According to an embodiment, at least one board (layer) to which the lead wire of the temperature sensor 2600 is soldered may be the lowermost layer of the heating coil board 10. The lead wire of the temperature sensor 2600 may be referred to simply as a 'lead' throughout the present disclosure.

An insulating layer may be inserted between the heating coil pattern layers. According to the induction heating device 2000 having the heating coil board 10 as described above, the heating coil board 10 has a stack structure of four or more layers, and thus the thickness of one layer of the heating coil, for example, the copper thickness, may be thin, for example, to about 60 um and a pattern width may be reduced, thereby reducing the influence of the skin effect and reducing coil loss. This is merely one example, and the heating coil board 10 may have a stack structure of five or more layers, which is more than four layers.

In the heating coil board 10, one or more coil patterns are formed on each pattern layer of the plurality of heating coil pattern layers. For example, the coil pattern CP may be spiral. According to an embodiment, the coil pattern CP may be formed by a plurality of coil elements that are approximately rectangular in plan view, as illustrated in FIG. 8. According to an embodiment, the coil pattern CP may be formed by the plurality of coil elements that are circular in plan view. The shape of the coil element constituting the coil pattern CP is not limited to the shape described above. The heating coil board 10 may include a plurality of serial pattern groups. The plurality of serial pattern groups may be connected in parallel with each other. Each of the plurality of serial pattern groups may have a plurality of serially connected coil patterns CPs. The plurality of serial pattern groups may be formed such that coil patterns formed on adjacent pattern layers among the plurality of pattern layers are connected in parallel with each other. As such, coils formed on the plurality of pattern layers may form a parallel connection relationship, and heating coil loss may be reduced while ensuring a large current capacity. The plurality of coil patterns CP constituting each of the plurality of serial pattern groups may be formed on four or more pattern layers. At least one of the plurality of serial pattern groups may have a different combination of the plurality of pattern layers from the other serial pattern groups. As such, a wiring structure may be simplified, the number of interlayer connections may be reduced, and power loss may be reduced accordingly. In other words, by reducing an impedance gap between parallel-connected serial pattern groups due to mutual impedance in each pattern layer, efficiency characteristics equivalent to a theoretical entire layer (whole layer) serial connection structure may be maintained. The number of interlayer connections may be reduced compared to the entire-layer serial connection structure, and thus interlayer wiring resistance may be lowered, enabling a lower-loss design than the entire-layer serial connection structure. The plurality of serial pattern groups may have at least two serial pattern groups having the same combination of the plurality of pattern layers. As such, the number of interlayer connections may be reduced.

According to an embodiment, the heating coil board 10 may have two terminals (an input terminal 2a and an output terminal 2b) formed on an outer periphery of the coil pattern CP for connecting the plurality of serial pattern groups provided in each stack layer in parallel. The electrical connection between the pattern layers may be made by a conductor (through hole TH or via hole) formed to pass through the heating coil board 10. The through hole TH may be formed to pass through all of the pattern layers PL and enable electrical connection between layers.

In the heating coil board 10 according to an embodiment of the present disclosure, the coil patterns CP may be connected such that a side of the input terminal 2a is the uppermost layer among the plurality of pattern layers, and a side of the output terminal 2b is the lowermost layer among the plurality of pattern layers PL. According to this configuration, when multilayer coil patterns CP are formed, a low power sensor may be mounted on an upper layer, and the low power sensor may be easily formed into a thin film structure.

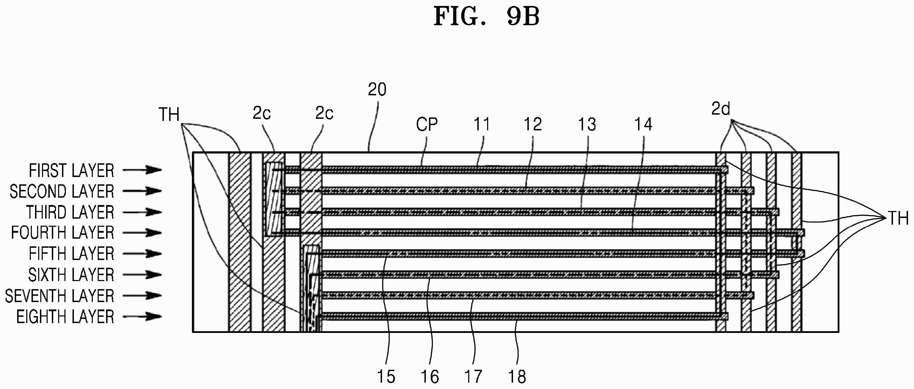

FIG. 9B is a cross-sectional view showing interlayer connection of a heating coil board according to an embodiment of the present disclosure.

FIG. 9B is a cross-sectional view illustrating interlayer connection in an eight-layer heating coil board 10 according to an embodiment of the present disclosure. Referring to FIG. 9B, the heating coil board 10 may be a PCB board formed by stacking four or more pattern layers PL on which the coil patterns CP are formed. An insulating layer including two or more layers of prepreg insulating layers may be provided between the pattern layers.

According to an embodiment of the present disclosure, FIG. 9B illustrates the heating coil board 10 formed by stacking eight heating coil pattern layers (first to eighth layers). According to an embodiment, the heating coil board 10 includes four heating coil pattern layers 11, 12, 13, and 14 and other four heating coil pattern layers 15, 16, 17, and 18. According to an embodiment, each of the four heating coil pattern layers 11, 12, 13, and 14 may have four coil patterns CP connected in series. The four heating coil pattern layers 11, 12, 13, and 14 are connected in parallel to each other through a through hole TH 2c.

In FIG. 9B, pattern layers of the plurality of heating coil pattern layers 11, 12, ..., and 18 from the top are referred to as a first heating coil pattern layer 11, a second heating coil pattern layer 12, a third heating coil pattern layer 13, a fourth heating coil pattern layer 14, a fifth heating coil pattern layer 15, a sixth heating coil pattern layer 16, a seventh heating coil pattern layer 17, and an eighth heating coil pattern layer 18, respectively.

Referring to FIG. 9B, the first heating coil pattern layer 11 may be connected in series with the eighth heating coil pattern layer 18 formed on the eighth layer through a through hole 2d. The second heating coil pattern layer 12 may be connected in series with the seventh heating coil pattern layer 17 formed on the seventh layer through the through hole 2d. The third heating coil pattern layer 13 of the third layer may be connected in series with the sixth heating coil pattern layer 16 formed on the sixth layer through the through hole 2d. The fourth heating coil pattern layer 14 of the fourth layer may be connected in series with the fifth heating coil pattern layer 15 formed on the fifth layer through the through hole 2d.

As such, the heating coil pattern layers 11, 12, 13, and 14 illustrated in FIGS. 9A and 9B have different combinations of pattern layers connected in series. When the four heating coil pattern layers 11, 12, 13, and 14 are connected in parallel, the coil patterns CP formed on different pattern layers may be connected in parallel.

In the heating coil board 10 according to an embodiment of the present disclosure, the coil patterns CP may be connected such that a side of the input terminal 2a is the uppermost layer among the plurality of heating coil pattern layers, and a side of the output terminal 2b is the lowermost layer among the plurality of heating coil pattern layers. According to this configuration, when the plurality of heating coil pattern layers are formed, if a low power sensor is mounted, it is easy to form the low power sensor in a thin film structure. The low power sensor may include a vessel detection coil.

A multilayer structure of the heating coil board 10 is not limited to the eight-layer structure described above.

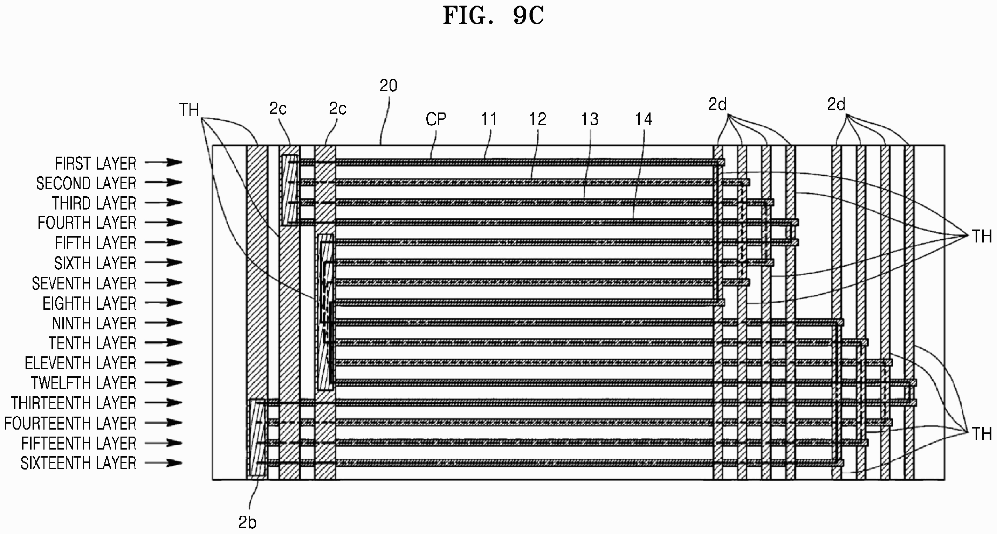

FIG. 9C is a cross-sectional view of series and parallel connections between a 16-layer heating coil board and a heating coil board according to an embodiment of the present disclosure.

According to the connection cross-section illustrated in FIG. 9C, a stack method is the same as in FIG. 9B in that a plurality of coil patterns connected in series are provided in one heating coil pattern layer.

One heating coil board 10 may include the plurality of serial pattern groups. The plurality of serial pattern groups may be connected in parallel with each other. Each of the plurality of serial pattern groups may have a plurality of serially connected coil patterns CPs. The plurality of serial pattern groups may be formed such that adjacent pattern layers among the plurality of heating coil pattern layers are connected in parallel with each other. As such, coils formed on the plurality of heating coil pattern layers may form a parallel connection relationship, and a large current capacity may be ensured. The plurality of coil patterns CP constituting each of the plurality of serial pattern groups may be formed in four or more pattern layers. At least one of the plurality of serial pattern groups may have a different combination of the plurality of heating coil pattern layers from the other serial pattern groups. As such, a wiring structure may be simplified, the number of interlayer connections may be reduced, and power loss may be reduced accordingly. That is, by lowering an impedance gap between the parallelly connected serial pattern groups due to mutual impedance in each heating coil pattern layer, efficiency characteristics equivalent to an entire-layer series connection structure may be theoretically maintained. The number of interlayer connections may be reduced compared to the entire-layer serial connection structure, and thus interlayer wiring resistance may be lowered, enabling a lower-loss design than the entire-layer serial connection structure. The plurality of serial pattern groups may have at least two serial pattern groups having the same combination of the plurality of heating coil pattern layers. As such, the number of interlayer connections may be reduced.

According to an embodiment of the present disclosure, FIG. 9C illustrates the heating coil board 10 formed by stacking 16 pattern layers (first to sixteenth layers). Acording to an embodiment, the heating coil board 10 includes the four heating coil pattern layers 11, 12, 13, and 14. According to an embodiment, each of the four heating coil pattern layers 11, 12, 13, and 14 may have four coil patterns CP connected in series. The four heating coil pattern layers 11, 12, 13, and 14 are connected in parallel to each other through a through hole 2c.

For example, referring to FIG. 9C, the first heating coil pattern layer 11 of a first layer may be connected in series with the heating coil pattern layer CP formed in an eighth layer. The second heating coil pattern layer 12 of a second layer may be connected in series with the heating coil pattern layers CP formed in a seventh layer, a tenth layer, and a fifteenth layer. The third heating coil pattern layer 13 of a third layer may be connected in series with the heating coil pattern layers CP formed in a sixth layer, an eleventh layer, and a fourteenth layer. The fourth heating coil pattern layer 24 of the fourth layer may be connected in series with the heating coil pattern layers CP formed in a fifth layer, a twelfth layer, and a thirteenth layer.

As such, the heating coil pattern layers 11, 12, 13, and 14 illustrated in FIG. 9C have different combinations of heating coil pattern layers connected in series. When the four heating coil pattern layers 11, 12, 13, and 14 are connected in parallel, the coil patterns CP formed on different heating coil pattern layers may be connected in parallel.

According to an embodiment of the present disclosure, electrical connection between heating coil pattern layers is formed by a conductor (through hole TH) formed to pass through the heating coil board 10. The through hole TH is formed to pass through all heating coil pattern layers. Four coil patterns CP constituting each of the heating coil pattern layers 11, 12, 13, and 14 may be connected in series by one intermediate terminal 2c formed of a conductor installed on an outer periphery of the coil pattern CP and a plurality of connection terminals 2d formed of a conductor installed on an inner periphery of the coil pattern CP.

In the heating coil board 10 according to the embodiment, the coil patterns CP may be connected such that a side of the input terminal 2a is the uppermost layer among the plurality of heating coil pattern layers, and a side of the output terminal 2b is the lowermost layer among the plurality of heating coil pattern layers. According to this configuration, when the plurality of heating coil pattern layers are formed, if a low power sensor is mounted, it is easy to form the low power sensor in a thin film structure. According to an embodiment of the present disclosure, the low power sensor may include a vessel detection coil as a vessel detection sensor.

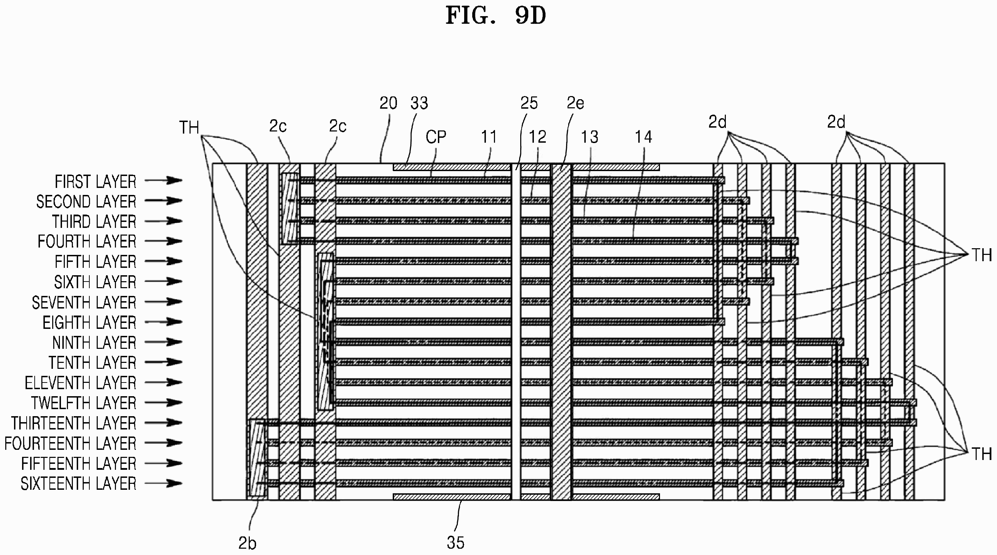

FIG. 9D is a cross-sectional view showing interlayer connection of a heating coil board including a hole for a temperature sensor according to an embodiment of the present disclosure.

The heating coil board 10 illustrated in FIG. 9D includes a vessel detection coil layer 33 including a vessel detection coil on the uppermost layer. According to an embodiment of the present disclosure, the heating coil board 10 may include the hole 25 in which the temperature sensor 2600 is to be mounted.

A vessel detection coil layer 33 according to an embodiment of the present disclosure is a pattern layer having a plurality of vessel detection coils printed thereon for detecting the cooking vessel 101 placed on the top plate of the induction heating device 2000.

According to an embodiment of the present disclosure, at least two prepreg insulating layers may be provided between the vessel detection coil layer 33 and the first heating coil pattern layer 11 to adhere the two layers while insulating therebetween. According to an embodiment, each of the two prepreg insulating layers may be an insulating layer including resin content of 60 % to 80 %.

According to an embodiment of the present disclosure, the heating coil board 10 illustrated in FIG. 9D is generated by hot-pressing a stack board including the vessel detection coil layer 33, the first to sixteenth heating coil pattern layers, and a connector connection board 35 as the lowermost layer. According to an embodiment of the present disclosure, a conductor of the vessel detection coil layer 33 of the uppermost layer of the stack board or a conductor provided in any one of the first to sixteenth heating coil pattern layers may not be in contact with reinforcing fibers of the prepreg insulating layer during hot pressing, and thus insulation may be maintained.

According to an embodiment, a first end of each of the plurality of vessel detection coils provided in the vessel detection coil layer 33 may be connected to the connector connection board 35, which is the lowermost layer, to pass through the heating coil board 10 via a through hole 2e. A first end of a vessel detection coil connected through the through hole 2e to the connector connection board 35 may be connected to a connector mounted on the connector connection board 35. A second end of each vessel detection coil may be connected to a terminal of a connector provided on the heating coil board 10 above the vessel detection coil layer 33. The first and second ends of each of the plurality of vessel detection coils may be connected to a processor provided in the inverter board 30 including an inverter circuit or an intermediate board 20 including a memory through a connector.

According to an embodiment, the through hole 2e connected to each of the first ends of the vessel detection coils of the vessel detection coil layer 33 may be provided with a minimum space in a coil pattern of the heating coil, through which the through hole 2e is capable of passing vertically, such that the through hole 2e may not come into contact with the conductor of the first to sixteenth heating coil pattern layers when passing through the first to sixteenth heating coil pattern layers.

According to an embodiment, the hole 25 through which the temperature sensor 2600 is to be located may be a hole that passes through the entire heating coil board 10. The hole 25 may be formed to pass through the heating coil board 10 to be insulated from the heating coil.

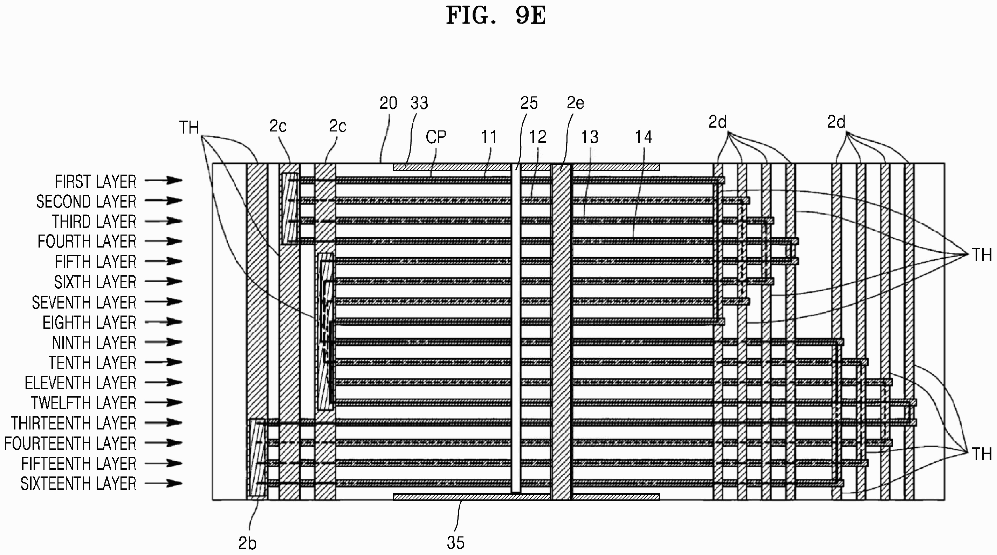

FIG. 9E is a cross-sectional view showing interlayer connection of a heating coil board including a hole for a temperature sensor according to an embodiment of the present disclosure.

The cross-sectional view of the heating coil board 10 of FIG. 9E and a cross-sectional view of FIG. 9D are different in that the hole 25 for the temperature sensor 2600 does not completely pass through the heating coil board 10. The hole 25 for the temperature sensor 2600 illustrated in FIG. 9E is stopped at the connector connection board 35, which is a connector connection layer. The connector connection board 35 is a board provided in the heating coil board 10 and is a board on which a signal line is located to be connected to another board, for example, the intermediate board 20 or the inverter board 30, by a connector. According to an embodiment, a lead wire of the temperature sensor 2600 may be soldered directly to the connector connection board 35.

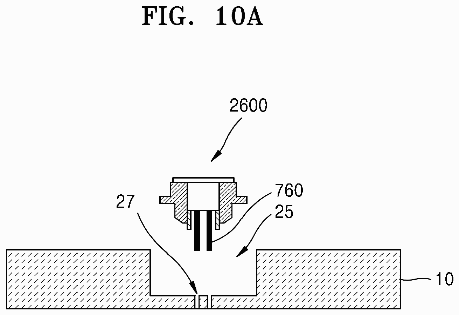

FIG. 10A is a diagram showing a temperature sensor mounted on a heating coil board according to an embodiment of the present disclosure.

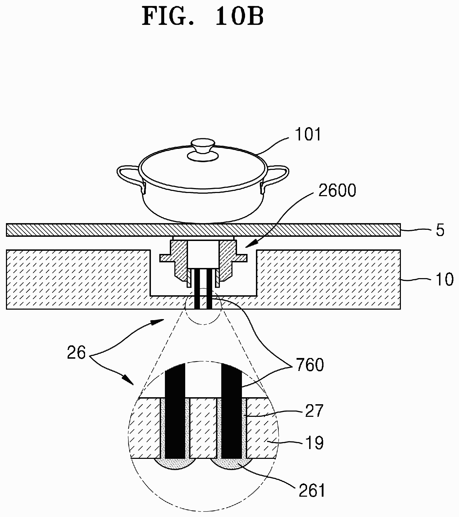

The temperature sensor 2600 may be located in the hole 25 of the heating coil board 10. According to an embodiment, a lead wire 760 of the temperature sensor 2600 may be received and soldered into a lead wire hole 27 provided in at least one board of the heating coil board 10. The lead wire 760 of the temperature sensor 2600 is not a flexible line like a wire, but a line that is fixed to move vertically. FIG. 10B shows a state in which the temperature sensor 2600 illustrated in FIG. 10A is mounted on the heating coil board 10.

FIG. 10B is a cross-sectional view showing a temperature sensor mounted on an induction heating device according to an embodiment of the present disclosure.

Referring to FIG. 10B, the temperature sensor 2600 is illustrated to be mounted in the hole 25 of the heating coil board 10 according to an embodiment of the present disclosure. At least one board 19 of the heating coil board 10 may include the lead wire hole 27 to solder the lead wire 760 of the temperature sensor 2600. According to an embodiment, the at least one board 19 of the heating coil board 10 may be the connector connection board 35 that is the lowermost layer of the heating coil board 10.

The temperature sensor 2600 may be in contact with or in close proximity to a top plate 5 of the induction heating device 2000 to detect the temperature of the top plate 5 or cooking vessel 101. Based on the temperature detected by the temperature sensor 2600, the induction heating device 2000 may control a heating level.

A portion 26 showing in more detail a state in which the lead wire 760 of the temperature sensor 2600 is soldered to the lead wire hole 27 of the at least one board 19 of the heating coil board 10 is illustrated in a lower side of FIG. 10B. According to an embodiment, the lead wire 760 of the temperature sensor 2600 may be soldered into and pass through the lead wire hole 27 provided in the at least one board 19 of the heating coil board 10. In this case, lead may be filled between the lead wire 760 of the temperature sensor 2600 and an outer wall of the lead wire hole 27, and thus the lead wire 760 of the temperature sensor 2600 may be soldered to the outer wall of the lead wire hole 27. The lead wire 760 of the temperature sensor 2600 may pass through the lead wire hole 27, and a lower end 261 of the lead wire hole 27 may be soldered such that the lead wire 760 of the temperature sensor 2600 may be covered with lead. In the above manner, when the temperature sensor 2600 is provided on the heating coil board 10 and a fixed lead wire 760 is mounted in the lead wire hole 27, the lead wire 760 may be automatically soldered.

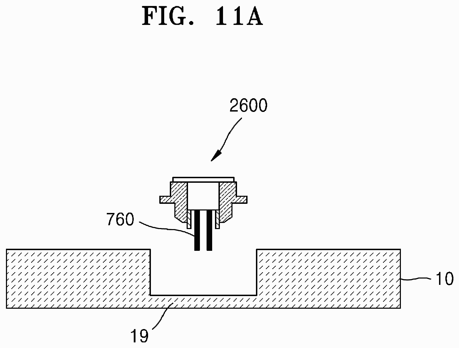

FIG. 11A is a diagram showing a temperature sensor mounted on a heating coil board according to an embodiment of the present disclosure.

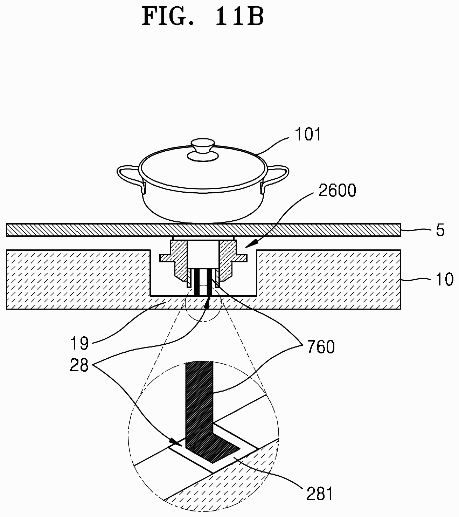

The temperature sensor 2600 may be located in the hole 25 of the heating coil board 10. At least one board of the heating coil board 10 may not include the hole 25 and the temperature sensor 2600 may be soldered thereon. According to an embodiment, the lead wire 760 of the temperature sensor 2600 may be soldered using surface mount technology (SMT) on at least one board of the heating coil board 10. FIG. 11B shows that the temperature sensor 2600 illustrated in FIG. 11A is soldered on at least one board of the heating coil board 10.

FIG. 11B is a cross-sectional view showing a temperature sensor mounted on an induction heating device according to an embodiment of the present disclosure.

Referring to FIG. 11B, the lead wire 760 of the temperature sensor 2600 is illustrated to be soldered to the at least one board 19 of the heating coil board 10 according to an embodiment of the present disclosure. The at least one board 19 of the heating coil board 10 may include a soldering pattern such that the lead wire 760 of the temperature sensor 2600 may be soldered by SMT. According to an embodiment, the at least one board 19 of the heating coil board 10 may be the connector connection board 35 that is the lowermost layer of the heating coil board 10.

The temperature sensor 2600 may be in contact with or in close proximity to the top plate 5 of the induction heating device 2000 to detect the temperature of the top plate 5 or the cooking vessel 101. Based on the temperature detected by the temperature sensor 2600, the induction heating device 2000 may control a heating level.

According to an embodiment, the lead wire 760 of the temperature sensor 2600 may have a suitable surface area to be in contact with a soldering pattern 281 of the at least one board 19 of the heating coil board 10. According to an embodiment, the lead wire 760 of the temperature sensor 2600 may have an end bent to ensure a surface area that comes into contact with the soldering pattern 281. In the above manner, the temperature sensor 2600 may be provided on the heating coil board 10, and the fixed lead wire 760 may be automatically soldered to the soldering pattern 281 for the lead wire, thereby simplifying an assembly process.

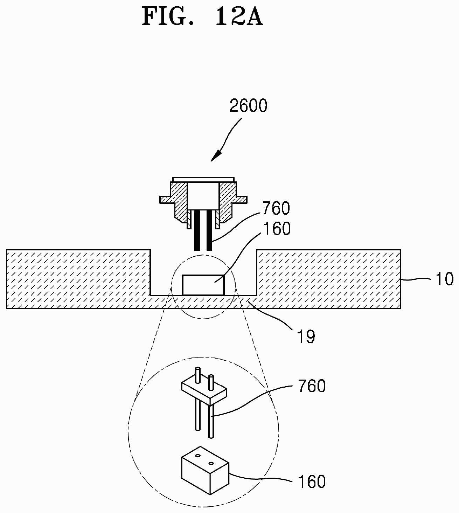

FIG. 12A is a diagram showing a temperature sensor mounted on a heating coil board according to an embodiment of the present disclosure.

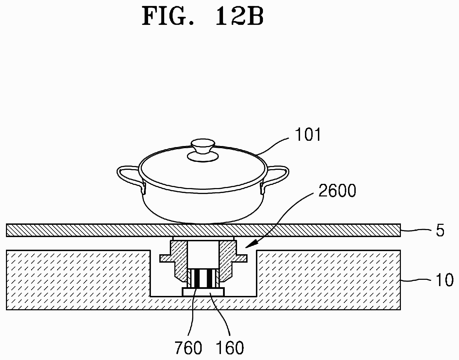

According to an embodiment, a temperature sensor connector 160 in which the lead wire 760 of the temperature sensor 2600 is to be accommodated may be soldered onto the at least one board 19 of the heating coil board 10. The temperature sensor connector 160 may be soldered on the at least one board 19 by SMT. The at least one board 19 of the heating coil board 10 may not need to include a hole for the lead wire 760 to pass through. The temperature sensor connector 160 to which the lead wire 760 of the temperature sensor 2600 is to be coupled may be soldered onto the at least one board 19 of the heating coil board 10. According to an embodiment, the temperature sensor connector 160 may be a female connector to accommodate the lead wire 760. FIG. 12B shows that the temperature sensor 2600 illustrated in FIG. 12A is mounted on the at least one board 19 of the heating coil board 10.

FIG. 12B is a cross-sectional view showing a temperature sensor mounted on an induction heating device according to an embodiment of the present disclosure.

FIG. 12B illustrates that the temperature sensor connector 160 is soldered to the at least one board 19 of the heating coil board 10 and the lead wire 760 of the temperature sensor 2600 is accommodated in the temperature sensor connector 160 according to an embodiment of the present disclosure. The temperature sensor connector 160 is soldered on the at least one board 19 of the heating coil board 10 by SMT. According to an embodiment, the at least one board 19 of the heating coil board 10 may be the connector connection board 35 that is the lowermost layer of the heating coil board 10.

The temperature sensor 2600 may be in contact with or in close proximity to the top plate 5 of the induction heating device 2000 to detect the temperature of the top plate 5 or the cooking vessel 101. Based on the temperature detected by the temperature sensor 2600, the induction heating device 2000 may control a heating level.

According to an embodiment, the lead wire 760 of the temperature sensor 2600 may be mounted directly on the temperature sensor connector 160 soldered on the at least one board 19 of the heating coil board 10, and thus a separate soldering process of the temperature sensor 2600 may be omitted. In the above manner, the lead wire 760 of the temperature sensor 2600 may be directly connected to the temperature sensor connector 160 that is already soldered on the at least one board 19 of the heating coil board 10, and thus the assembly process may be simplified and the durability of the induction heating device 2000 may also be improved due to absence of wires.

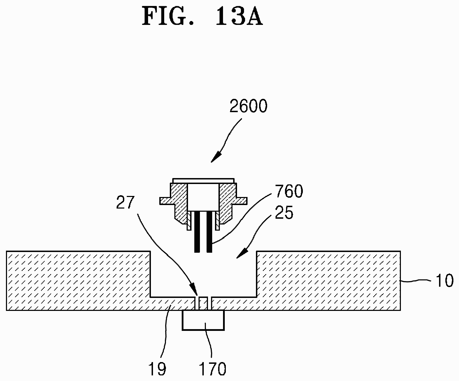

FIG. 13A is a diagram showing a temperature sensor mounted on a heating coil board according to an embodiment of the present disclosure.

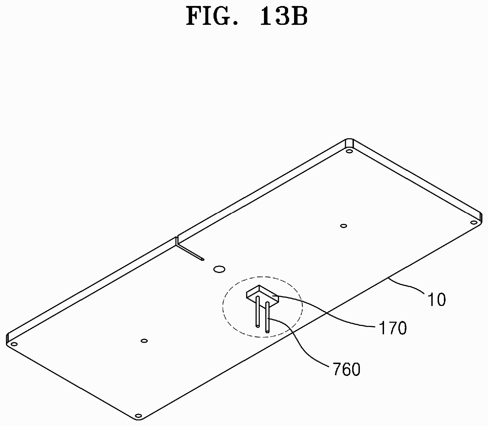

According to an embodiment, a temperature sensor connector 170 in which the lead wire 760 of the temperature sensor 2600 is to be accommodated may be soldered to a lower portion of the at least one board 19 of the heating coil board 10. The temperature sensor connector 170 may be soldered on the at least one board 19 by SMT. Here, the at least one board 19 of the heating coil board 10 may include a hole 27 for the lead wire 760 of the temperature sensor 2600 to pass through. The temperature sensor connector 170 to which the lead wire 760 of the temperature sensor 2600 is to be coupled may be soldered to the lower portion of the at least one board 19 of the heating coil board 10, and thus the at least one board 19 needs to be the lowermost layer of the heating coil board 10. According to an embodiment, the temperature sensor connector 170 may be a female connector to accommodate the lead wire 760. FIG. 13B shows that the temperature sensor 2600 illustrated in FIG. 13A is mounted on the at least one board 19 of the heating coil board 10.

FIG. 13B is a cross-sectional view showing a temperature sensor mounted on a rear surface of a heating coil board according to an embodiment of the present disclosure.

FIG. 13B illustrates that the temperature sensor connector 170 is soldered to a lower portion of the at least one board 19 of the heating coil board 10 and the lead wire 760 of the temperature sensor 2600 is accommodated in the temperature sensor connector 170 according to an embodiment of the present disclosure. The temperature sensor connector 170 is soldered to the lower portion of the at least one board 19 of the heating coil board 10 by SMT. According to an embodiment, the at least one board 19 of the heating coil board 10 may be the connector connection board 35 that is the lowermost layer of the heating coil board 10.

The temperature sensor 2600 may be in contact with or in close proximity to the top plate 5 of the induction heating device 2000 to detect the temperature of the top plate 5 or the cooking vessel 101. Based on the temperature detected by the temperature sensor 2600, the induction heating device 2000 may control a heating level.

According to an embodiment, the lead wire 760 of the temperature sensor 2600 may be mounted directly on the temperature sensor connector 170 soldered to the lower portion of the at least one board 19 of the heating coil board 10, and thus a separate soldering process of the temperature sensor 2600 to the heating coil board 10 may be omitted. In the above manner, the lead wire 760 of the temperature sensor 2600 may be directly connected to the temperature sensor connector 170 that is already soldered to the lower portion of the at least one board 19 of the heating coil board 10, and thus the assembly process may be simplified and the durability of the induction heating device 2000 may also be improved due to the absence of wires.

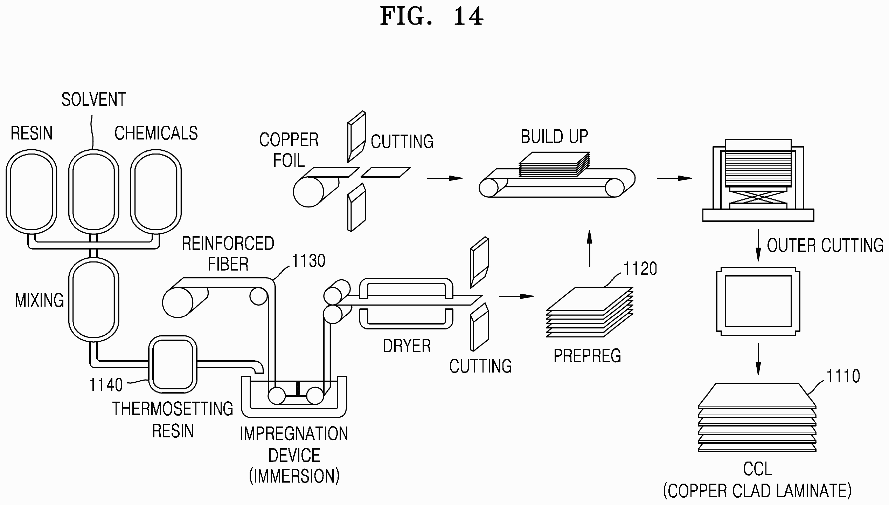

FIG. 14 illustrates a process of manufacturing a heating coil board of an induction heating device according to an embodiment of the present disclosure.

FIG. 14 illustrates a final production process of a copper clad laminate (CCL) 1110. The CCL is a PCB board formed by stacking a plurality of heating coil pattern layers. The CCL may be produced by bonding copper foil to one or both sides of a PCB core. The CCL is made by stacking copper foils on a preimpregnated material (prepreg) 1120.

The prepreg 1120 is a sheet-shaped resin product obtained by previously impregnating a matrix into a reinforced fiber 1130, and is made into a semi-cured state by impregnating the reinforced fiber 1130 with a thermosetting resin 1140. Prepreg is not only an insulator, but is also used as an adhesive to bond each heating coil pattern layer.

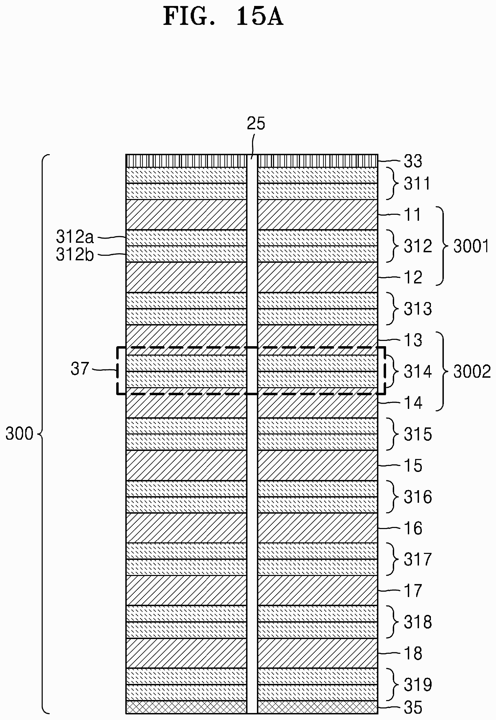

FIG. 15A is a diagram illustrating a heating coil board layer by layer according to an embodiment of the present disclosure.

As shown in FIG. 15A, a stack board 300 according to an embodiment of the present disclosure may include eight plurality of heating coil pattern layers 11, 12, ..., and 18 and nine plurality of insulating layers 311, 312, ..., and 319. One insulating layer 312 includes, for example, two prepreg insulating layers 312a and 312b. The heating coil board 10 is generated by hot-pressing the upper stack board 300.

The PCB board used to make a board constituting one heating coil pattern layer 11 in FIG. 15A has a size of 1020 (mm) x 1200 (mm) or 1020 (mm) x 1020 (mm). When a board is manufactured by printing a heating coil pattern on the PCB board, to supply high power while reducing a skin effect, the thickness of copper patterned as a conductor and the width of the heating coil pattern need to be narrow. At the same time, current capacity may be ensured by connecting the plurality of plurality of heating coil pattern layers 11, 12, ..., and 18 in parallel. However, to connect the plurality of plurality of heating coil pattern layers 11, 12, ..., and 18 in parallel, the number of interlayer connections increases and coil loss due to wiring length also increases. To reduce the number of interlayer connections while reducing coil loss, a plurality of serially connected serial patterns among the plurality of plurality of heating coil pattern layers 11, 12, ..., and 18 may be provided. The plurality of serial patterns may be connected in parallel with each other. According to an embodiment, at least one serial pattern may be stacked in four or more layers.

According to an embodiment of the present disclosure, the upper four layers 11, 12, 13, and 14 among the plurality of plurality of heating coil pattern layers 11, 12, ..., and 18 may be electrically connected in parallel. The lower four layers 15, 16, 17, and 18 among the plurality of plurality of heating coil pattern layers 11, 12, ..., and 18 may be electrically connected in parallel. Here, the 'upper' and 'lower' are relative terms, but among the plurality of heating coil pattern layers 11, 12, ..., and 18, the one closer to the top plate of the induction heating device 2000 may be called 'upper'.

Four layers of heating coil pattern layers electrically connected in parallel with each other may be connected in series with each other. The serial connection between the heating coil pattern layers may be made between the first heating coil pattern layer 11 and the eighth heating coil pattern layer 18, the second heating coil pattern layer 12 and the seventh heating coil pattern layer 17, the third heating coil pattern layer 13 and the sixth heating coil pattern layer 16, and the fourth heating coil pattern layer 14 and the fifth heating coil pattern layer 15. A detailed description has already been given with reference to FIG. 10B.

However, this is merely one example, and when the heating coil pattern layer includes only the first heating coil pattern layer 11 to the fourth heating coil pattern layer 14, the first heating coil pattern layer 11 and the second heating coil pattern layer 12 may be electrically connected in parallel with each other, and the third heating coil pattern layer 13 and the fourth heating coil pattern layer 14 may be electrically connected in parallel with each other. The first heating coil pattern layer 11 and the fourth heating coil pattern layer 14 may be electrically connected in series, and the second heating coil pattern layer 12 and the third heating coil pattern layer 13 may be electrically connected in series.

According to an embodiment, the thickness of each heating coil pattern layer in the plurality of heating coil pattern layers 11, 12, ..., and 18 may be 60 um to 82 um.

According to an embodiment, the thickness of the heating coil board 10 formed by hot-pressing the stack board 300 including the vessel detection coil layer 33, the connector connection board 35, and a plurality of heating coil pattern layers of 18 layers may be less than or equal to 3.3 mm. However, this is merely one example, and the thickness of the heating coil board 10 generated by hot-pressing the stack board 300 may be between 2.5 mm and 4.0 mm.

When a manufacturer of the induction heating device 2000 orders a CCL, the CCL may be manufactured in a form that includes two heating coil pattern layers and an insulating layer therebetween. In this case, an insulating layer may be inserted between a plurality of CCLs to generate the stack board 300. In this case, the insulating layer may be generated by stacking two prepreg insulating layers.

Referring to FIG. 15A, a first CCL 3001 may include the first heating coil pattern layer 11, the insulating layer 312, and the second heating coil pattern layer 12. A second CCL 3002 may include the third heating coil pattern layer 13, the insulating layer 314, and the fourth heating coil pattern layer 14. When the manufacturer of the induction heating device 2000 obtains the ordered CCL, the stack board 300 may be generated by stacking CCLs and stacking insulating layers therebetween. For example, the insulating layer 313 may be inserted between the first CCL 3001 and the second CCL 3002. The insulating layer 313 may be generated by stacking two prepreg insulating layers.

Finally, when the stack board 300 is hot-pressed, the CCLs are already hot-pressed, and thus are hardly hot-pressed, and instead, a hot-press ratio of the insulating layer between the CCLs, for example, the insulating layer 313 is high. According to an embodiment, the insulating layer between the CCLs, for example, the insulating layer 312 may have a thickness less than or equal to 140 um after hot pressing. In contrast, the insulating layer between the CCLs, for example, the insulating layer 313 may have a thickness less than or equal to 120 um after hot pressing.

The stack board 300 according to an embodiment of the present disclosure may include the hole 25 in which the temperature sensor 2600 for detecting the temperature of the cooking vessel 101 or the temperature of the top plate 5 is to be mounted. The hole 25 may be formed to vertically pass through the stack board 300 without contact with the heating coil pattern. The hole 25 in which the temperature sensor 2600 illustrated in FIG. 15A is to be mounted may be formed to pass through the stack board 300, but the lowermost layer, the connector connection board 35, may only include a hole through which only the lead wire 760 of the temperature sensor 2600 may pass. Therefore, the stack board 300 illustrated in FIG. 15A may be used in a mounting method of the temperature sensor 2600 illustrated in FIG. 10A and FIG. 13A.

In FIG. 15A, the number of heating coil pattern layers is shown as eight, but this is merely one example, and according to an embodiment of the present disclosure, the number of heating coil pattern layers may be adjusted according to design. For example, the number of heating coil pattern layers may be four. Alternatively, according to an embodiment, a heating coil board including a total of 16 heating coil pattern layers formed by stacking 8 CCLs including two heating coil pattern layers and an insulating layer therebetween may be used.

According to an embodiment of the present disclosure, the uppermost layer of the stack board 300 may include the vessel detection coil layer 33 that includes only a vessel detection coil for detecting whether a cooking vessel is placed on the top plate 5 of the induction heating device 2000. This is merely one example, and the vessel detection coil may be patterned and provided together with the heating coil in the first heating coil pattern layer 11, which is the uppermost heating coil pattern layer of the plurality of heating coil pattern layers 11, 12, ..., and 18. When the vessel detection coil is patterned together with the heating coil pattern layer, induced power may be injected into the vessel detection coil by the heating coil. Thus, according to an embodiment, the stack board 300 may be designed such that the vessel detection coil is provided in the vessel detection coil layer 33 separate from the heating coil pattern layer. According to an embodiment, the vessel detection coil layer 33 may have a thickness less than or equal to 110 um after hot pressing.

The insulating layer 311 including two prepreg insulating layers may be located between the vessel detection coil layer 33 and the first heating coil pattern layer 11 for insulation and adhesion. The insulating layer 311 located between the vessel detection coil layer 33 and the first heating coil pattern layer 11 may be thinner than the insulating layer 312 including two prepreg insulating layers located between the first heating coil pattern layer 11 and the second heating coil pattern layer 12. According to an embodiment, the thickness of the insulating layer 311 located between the vessel detection coil layer 33 and the first heating coil pattern layer 11 may be less than or equal to 130 um. The amount of copper (0.5 to 1 ounce (oz)) used on the PCB board to manufacture the vessel detection coil layer 33 may be less than the amount of copper (2 to 3 oz) used in the heating coil pattern layer. The reason is that the vessel detection coil of the vessel detection coil layer 33 is used for sensing a cooking vessel, and thus the amount of copper used is less than the heating coil for high power.

The vessel detection coil provided in the vessel detection coil layer 33 may detect when the cooking vessel 101 is located on the top plate of the induction heating device 2000. When the vessel detection coil of the induction heating device 2000 detects the cooking vessel 101, the processor of the induction heating device 2000 may display information such as identification information of the cooking vessel 101 detected through the vessel detection coil, location information of the cooking vessel 101, presence or absence of the cooking vessel 101, and material of the cooking vessel 101 on a display provided in the user interface.

According to an embodiment of the present disclosure, the lowermost layer of the stack board 300 may include the connector connection board 35 on which a connector is mounted to connect the heating coil board 10 and the inverter board of the induction heating device 2000 with a connector. According to an embodiment, the connector connection board 35 may have a thickness less than or equal to 110 um after hot pressing. An insulating layer 319 on which two prepreg insulating layers are stacked for insulation and adhesion may be located between the connector connection board 35 and the eighth heating coil pattern layer 18. The insulating layer 319 formed by stacking two prepreg insulating layers located between the connector connection board 35 and the eighth heating coil pattern layer 18 may be thinner than an insulating layer 318 formed by stacking two prepreg insulating layers located between the seventh heating coil pattern layer 17 and the eighth heating coil pattern layer 18. According to an embodiment, when the thickness of the insulating layer 319 located between the connector connection board 35 and the eighth heating coil pattern layer 18 is less than or equal to 120 um, the thickness of the insulating layer 318 located between the seventh heating coil pattern layer 17 and the eighth heating coil pattern layer 18 may be less than or equal to 130 um, which is slightly thicker than this. The amount of copper (0.5 to 1 oz) used on the PCB board to manufacture the connector connection board 35 may be less than the amount of copper (2 to 3 oz) used in the heating coil pattern layer. The reason is that a signal coil of the connector connection board 35 is used for signal transmission, and thus the amount of copper used is less than that of the heating coil for high power.

When a heating coil is patterned on a PCB as in FIG. 15A, the manufacturing process may be simplified and manufacturing costs may be reduced compared to when the heating coil is manufactured by winding the Litz wire. When the heating coil is patterned on the PCB, the inductance accuracy of the heating coil is higher than when the heating coil is manufactured by winding the Litz wire, and thus a constant heating level may be ensured.

When the heating coil is patterned on the PCB, copper usage may be reduced as only 1/3 of the copper is used for the same heating output compared to manufacturing the heating coil by winding the Litz wire.

When 1 ounce (oz) of copper is used on a PCB board (1020 (mm)x1200 (mm) or 1020 (mm)x1020 (mm)) used to manufacture a heating coil pattern layer, insulation may be ensured between the plurality of insulating layers 311, 312, ..., and 319 and the plurality of plurality of heating coil pattern layers 11, 12, ..., and 18 when hot-pressing a stack board on which the PCB boards are stacked, but the amount of copper may be insufficient as the heating coil required for high power. Insufficient copper may cause overheating in the heating coil pattern and increase heat loss. To reduce the heat generated from the heating coil pattern, there is a method of widening the width of the heating coil pattern. However, when the pattern width is widened, it is difficult to ensure a large number of turns, and therefore, it is difficult to ensure an appropriate inductance, and it is difficult to widen the pattern width in terms of design. Therefore, there is a method of increasing the thickness of the heating coil pattern.

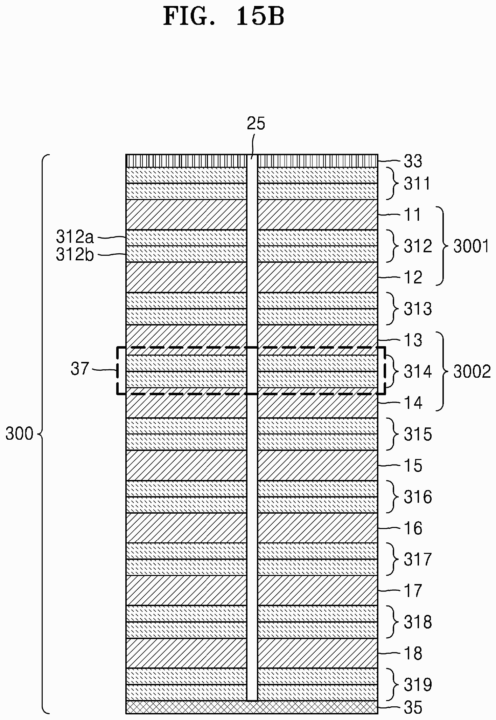

FIG. 15B is a diagram illustrating a heating coil board layer by layer according to an embodiment of the present disclosure.

The stack board 300 according to an embodiment of the present disclosure may include the hole 25 in which the temperature sensor 2600 for detecting the temperature of the cooking vessel 101 or the temperature of the top plate 5 is to be mounted.

The stack board 300 illustrated in FIG. 15B is different from the stack board 300 illustrated in FIG. 15A in that the hole 25 for the temperature sensor 2600 does not pass through the connector connection board 35, which is the lowermost layer. The hole 25 may be formed to vertically pass through the stack board 300 up to the connector connection board 35 without contact with the heating coil pattern. The connector connection board 35 illustrated in FIG. 15B may include a soldering pattern to which the lead wire 760 of the temperature sensor 2600 is to be directly soldered, or may include a pattern to which the temperature sensor connector 160, to which the lead wire 760 of the temperature sensor 2600 is to be directly connected, is to be soldered. Therefore, the stack board 300 illustrated in FIG. 15B may be used in a mounting method of the temperature sensor 2600 illustrated in FIG. 11A and FIG. 12A.

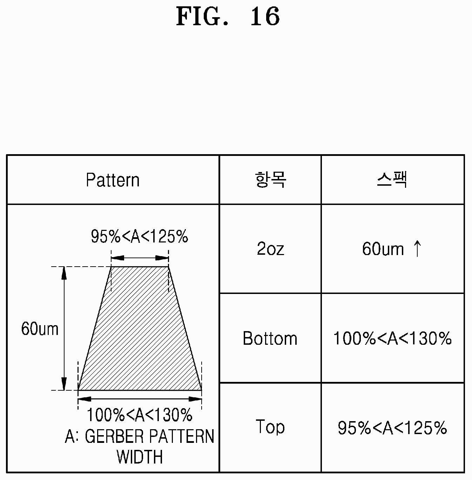

FIG. 16 is a diagram showing a heating coil pattern width specification according to an embodiment of the present disclosure.

Unlike a copper pattern of a typical PCB, the heating coil pattern needs to handle a lot of power capacity. Therefore, a large amount of current needs to flow through the patterned heating coil, and thus the pattern width needs to be greater than a normal copper pattern or the pattern thickness (height) needs to be thicker (higher).

To increase the thickness of the heating coil pattern, 2 oz of copper may be used on the PCB board instead of the existing 1 oz of copper.

Referring to FIG. 16, a cross-sectional view of a copper pattern using 2 oz of copper on a PCB board is shown. As shown in FIG. 16, the copper pattern is 35 um in height when 1 oz of copper is used, while the height is equal to or greater than 60 um when 2 oz of copper is used. The width (Gerber width) is a width requested by a customer who manufactures the induction heating device 2000. An upper portion of the pattern may be between 95 % and 125 % of the ordered width A, and a lower portion of the pattern may be between 100 % and 130 % of the ordered width A. Generally, when copper in a liquid state is melted, the copper takes a shape of a trapezoid with slightly different widths at the top and bottom, as shown in FIG. 16.

However, when 2 oz or more, e.g., 2 oz to 3 oz of copper is used, the copper becomes excessively thick, and when the stack board 300 illustrated in FIG. 15A or 15B is hot-pressed, one prepreg insulating layer 312a may be pressed in a liquefied state and comes into contact with the copper coil.

However, when 2 oz or more, e.g., 2 oz to 3 oz of copper is used, the copper becomes excessively thick, and when the stack board 300 illustrated in FIG. 15A or 15B is hot-pressed, one prepreg insulating layer 312a may be pressed in a liquefied state and comes into contact with the copper coil.

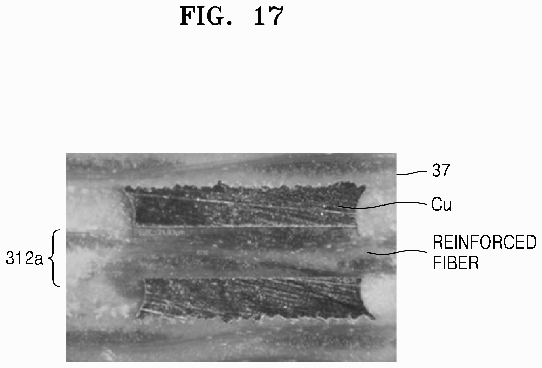

FIG. 17 shows a cross section 37 of a portion of a heating coil in FIG. 15A or FIG. 15B.

FIG. 17 is a diagram showing a cross section of a stack board according to an embodiment of the present disclosure.

The cross section 37 of a portion of the heating coil is now described, and a phenomenon occurs in which copper comes into contact with reinforced fibers provided in an intermediate insulating material due to hot pressing. Therefore, to prevent the phenomenon of copper coming into contact with the reinforced fibers as shown in FIG. 17, an insulating layer on which at least two prepreg layers are stacked is used according to an embodiment of the present disclosure. According to an embodiment, at least two prepreg layers may have a thickness less than or equal to about 140 um before being hot-pressed. According to an embodiment, at least two prepreg layers may have a thickness less than or equal to 130 to 140 um before being hot-pressed such that the thickness of the heating coil board after hot pressing may be less than or equal to 3.3 mm.

One prepreg insulating layer 312a may include resin contents, which may flow out when the PCB is made into a plurality of layers and the multi-layer PCB is hot-pressed. The resin contents flowing out comes into contact with the reinforced fibers provided in the prepreg insulating layer 312a, causing a portion in which the adhesiveness is reduced. When the adhesion between pattern layers by the prepreg insulating layer 312a is not property achieved, the heating coil pattern may be internally lifted as current flows through the heating coil, and when the heating coil pattern is lifted, moisture or air may enter the lifted internal portion, causing the PCB to swell. To prevent this phenomenon, a method of stacking two prepreg insulating layers 312a and 312b between heating coil pattern layers as an insulating layer, as in FIG. 15A or FIG. 15B, may be used.

The insulating layer uses a prepreg insulating layer having a resin content between 60 % (RC60) and 80 % (RC80) and is formed by stacking two or more layers of the prepreg insulating layers 312a and 312b. The thickness of one layer of the prepreg insulating layers 312a and 312b may be less than or equal to 70 um before hot pressing. Therefore, the prepreg insulating layers 312a and 312b may have a thickness less than or equal to 130 to 140 um before hot pressing. A resin content between 60 % (RC60) and 80% (RC80) means that resin accounts for 60 to 80 % of the total amount of the compound provided in the prepreg insulating layer.

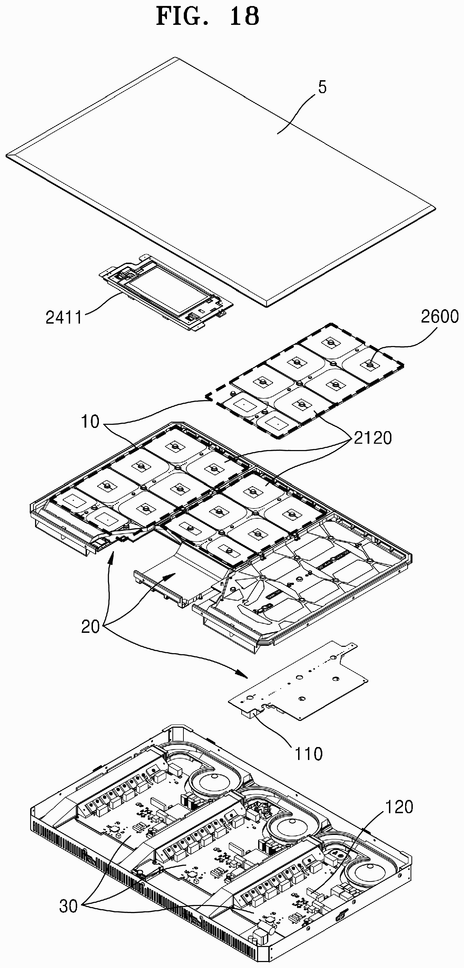

FIG. 18 illustrates a structure in which each board of an induction heating device is connected according to an embodiment of the present disclosure.

Referring to FIG. 18, the induction heating device 2000 according to an embodiment of the present disclosure may include the top plate 5 on which the cooking vessel 101 is placed, and the heating coil board 10 that is disposed below the top plate 5 and on which a plurality of heating coils are patterned and stacked. The induction heating device 2000 according to an embodiment of the present disclosure may include the intermediate board 20 including a relay and a resonance capacitor below the heating coil board 10. According to an embodiment, the intermediate board 20 may include a memory storing a program that controls the operation of the induction heating device 2000 and a processor that executes the program stored in the memory to control the induction heating device 2000.

The induction heating device 2000 according to an embodiment of the present disclosure may include the inverter board 30 including an inverter and a power conversion device below the intermediate board 20. The resonance capacitor may be provided in the inverter board 30 according to an embodiment. According to an embodiment, depending on the design specifications, the intermediate board 20 and the inverter board 30 may be combined into one inverter board. The inverter board 30 may include a plurality of electronic switches that constitute the inverter. The plurality of electronic switches perform PWM switching. PWM switching may induce an eddy current in the cooking vessel 101 by causing resonance between the heating coil 2120 provided in the heating coil board 10 and the resonance capacitor. The inverter board 30 may include a power conversion device for generating a DC low voltage used for the processor, memory, and the like provided in the intermediate board 20. The power conversion device may also generate a voltage of +15 V or +12 V for switching the plurality of electronic switches of the inverter. In the present disclosure, the power conversion device may be referred to as a switched mode power supply (SMPS).

According to an embodiment, the intermediate board 20 may be electrically connected to a second connector 120 mounted vertically on an upper surface of the inverter board 30 by accommodating a first connector 110 mounted vertically on a lower surface of the intermediate board 20 on the second connector 120. In this case, according to an embodiment, the electrical connection between the intermediate board 20 and the inverter board 30 may be made only by the connection between the first connector 110 and the second connector 120.

According to an embodiment, the first connector 110 mounted vertically on the lower surface of the intermediate board 20 may be a male connector, and the second connector 120 mounted vertically on the upper surface of the inverter board 30 may be a female connector. According to an embodiment, in contrast, the first connector 110 mounted vertically on the lower surface of the intermediate board 20 may be a female connector, and the second connector 120 mounted vertically on the upper surface of the inverter board 30 may be a male connector.

The temperature sensor 2600 is provided with each heating coil 2120. According to an embodiment, the temperature sensor 2600 may be directly connected to temperature sensor connectors 160 and 170 via the lead wire 760 as shown in FIGS. 12B and 13B.

As shown in FIG. 18, when the heating coil board 10, the intermediate board 20, and the inverter board 30 are connected through a connector and the lead wire 760 of the temperature sensor 2600 is connected to the connector, a wire for connection between the boards and a wire for the temperature sensor 2600 are no longer needed, and thus product defects due to wires do not occur. It does not cause any inconvenience in assembly or increase in manufacturing costs due to wires. Therefore, the structure in which the board and the temperature sensor 2600 are connected by a connector as shown in FIG. 18 may simplify product assembly and minimize product defects. The reason why this structure is possible is that the heating coil is patterned such that the heating coil board 10 is connected to the inverter board 30 only by a connector, and the lead wire 760 of the temperature sensor 2600 may also be connected to the connector provided on the heating coil board 10.

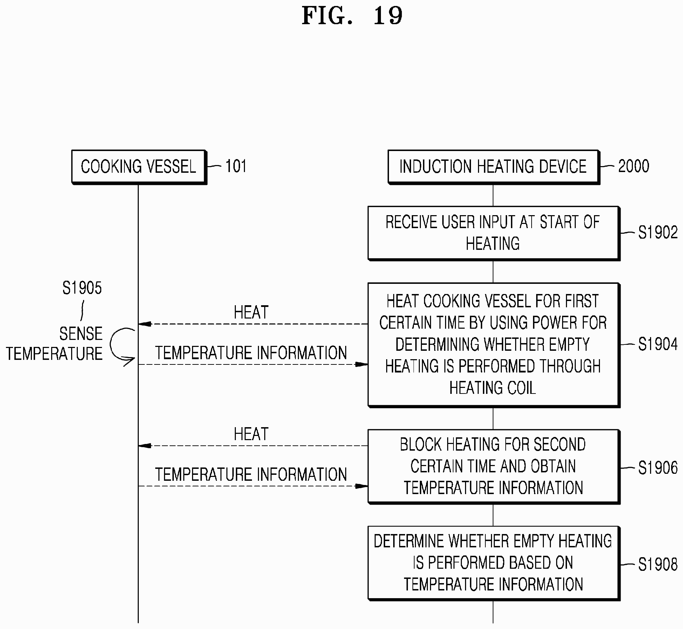

FIG. 19 is a sequence diagram for determining empty heating of a cooking vessel according to an embodiment of the present disclosure.

In operation S1902, the induction heating device 2000 receives a user input. The user input is a user input to heat the cooking vessel 101, and the corresponding user input may also include an input as to a level at which the cooking vessel 101 is to be heated. When a power level at which the cooking vessel 101 is to be heated is not specified by a user, heating may start at a default power level.

In operation S1904, the induction heating device 2000 heats the cooking vessel 101 for a first certain time by using power for determining whether empty heating is performed on the cooking vessel 101 rather than power input by a user through the heating coil.

In operation S1905, the cooking vessel 101 is heated by power received from the induction heating device 2000 and temperature information is obtained by the temperature sensor 2600. The length of the first certain time may vary depending on various conditions, but may be about 10 seconds, for example. The temperature sensor 2600 may continue to sense the temperature of the cooking vessel 101 unless there is a special reason for stopping the temperature measurement.

In operation S1906, the heating device 2000 blocks heating of the cooking vessel 101 for a second certain time, and during this time, continues to obtain temperature information sensed by the temperature sensor 2600. In operation S1908, the induction heating device 2000 determines whether empty heating is performed on the cooking vessel 101 based on the obtained temperature information.

To save resources, the induction heating device 2000 may selectively obtain temperature information only during the second certain time, or may selectively obtain temperature information only during the second certain time starting from a certain period of time (e.g., 2 seconds) immediately before the start of the second certain time.

When determining whether empty heating is performed on the cooking vessel 101, a processor 2200 of the heating device 2000 may determine that empty heating is performed on the cooking vessel 101 when the temperature of the cooking vessel 101 is a value that continues to rise for the second certain time or when the temperature rises abnormally abruptly.

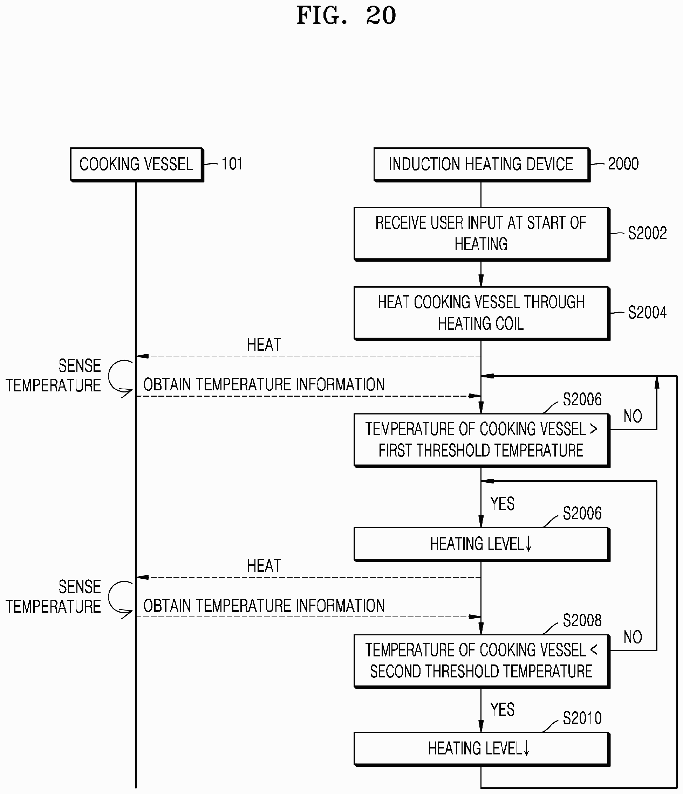

FIG. 20 is a sequence diagram for controlling an induction heating device based on overheating of a cooking vessel according to an embodiment of the present disclosure.

In operation S2002, the induction heating device 2000 receives a user input to initiate heating.

In operation S2004, according to the user input, the induction heating device 2000 generates a magnetic field in the heating coil to initiate heating, and the cooking vessel 101 begins to heat. When the cooking vessel 101 is heated, the induction heating device 2000 obtains temperature information of the top plate 5 or the cooking vessel 101 through the temperature sensor 2600.

In operation S2006, the processor of the induction heating device 2000 continues to maintain a heating level and continues to obtain temperature information through the temperature sensor 2600 when the temperature of the cooking vessel 101 is less than a first threshold temperature.

When the temperature of the cooking vessel 101 is greater than or equal to the first threshold temperature, the cooking vessel 101 is determined to be overheated, and in operation S2008, the induction heating device 2000 lowers a heating level by the heating coil. For example, when the heating level is from level 1 to level 10 and the heating level is 8, the induction heating device 2000 lowers the heating level to 7. For example, the first threshold temperature may be 130 degrees.

In operation S2008, the induction heating device 2000 compares the temperature of the cooking vessel 101 detected based on the temperature information obtained by the temperature sensor 2600 with a second threshold temperature. When the temperature of the cooking vessel 101 is greater than or equal to the second threshold temperature, the induction heating device 2000 may further lower the heating level in operation S2006. For example, when the heating level is currently 7, the heating level may be lowered to 6. The second threshold temperature may be, for example, 90 degrees.

When the temperature of the cooking vessel 101 is lower than the second threshold temperature, the induction heating device 2000 may increase the heating level again in operation S2010. For example, when the current heating level of the induction heating device 2000 is 7, the induction heating device 2000 may increase the heating level back to 8, which is a heating level previously specified by the user. According to an embodiment, when the heating level reaches the user-specified heating level, even if the temperature of the cooking vessel 101 is less than the second threshold temperature, the induction heating device 2000 does not increase the heating level. The induction heating device 2000 may continuously repeat operations S2006 to S2010 during heating.

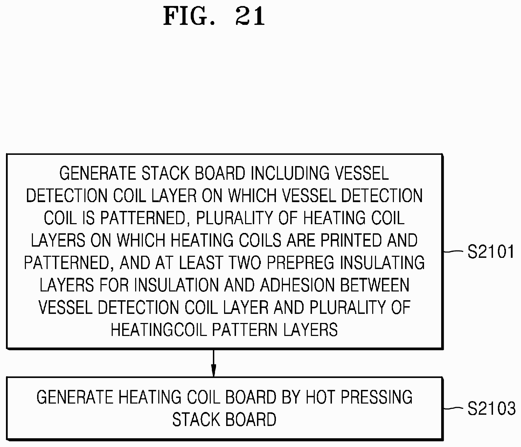

FIG. 21 is a flowchart of generating a heating coil board including a temperature sensor according to an embodiment of the present disclosure.

In operation 2101, a stack board is generated including a vessel detection coil layer on which a vessel detection coil is patterned, a plurality of heating coil layers on which heating coils are printed and patterned, and an insulating layer for insulation and adhesion between the vessel detection coil layer and the plurality of heating coil pattern layers. The insulating layer may be generated by stacking at least two prepreg insulating layers. The thickness of the insulating layer during hot pressing may be between 130 um and 140 um. The thickness of the vessel detection coil layer may be less than or equal to 110 um during hot pressing.

The vessel detection coil may be located on the uppermost layer of the stack board, and an insulating layer may also be inserted between the vessel detection coil layer and the uppermost layer of the plurality of heating coil pattern layers. The insulating layer may include two prepreg insulating layers. At least two prepreg insulating layers may be inserted between the plurality of heating coil pattern layers. The prepreg insulating layer described above may have a thickness less than or equal to 65 um before hot pressing. The lowermost layer of the stack board may include a connector connection board. An insulating layer may be inserted between the connector connection board and the lowermost layer of the plurality of heating coil pattern layers. The insulating layer may be generated by stacking at least two prepreg insulating layers. The thickness of the insulating layer during hot pressing may be between 130 um and 140 um. The thickness of the connector connection board may be less than or equal to 110 um during hot pressing.

In this case, the PCB board for generating the stack board may have a size of 1020 (mm)x1200 (mm) or 1020 (mm)x1020 (mm), and the PCB board used for manufacturing the heating coil board uses copper of 2 oz or more. The PCB board used for the vessel detection coil and the connector connection board may use 0.5 to 1 oz of copper.

Each prepreg insulating layer includes resin content of 60 % to 80 %.

In operation 2103, the stack board is hot pressed to generate a heating coil board. Even if the stack board is hot pressed, the prepreg insulating layer includes at least two layers, and thus there is no contact between the conductors of the plurality of heating coil pattern layers and the reinforced fiber of the prepreg insulating layer, thereby maintaining insulation. The thickness of the heating coil board generated by hot pressing may be less than or equal to 3.3 mm.

Each layer of the stack board may include the hole 25 through which the temperature sensor 2600 for detecting the temperature of the cooking vessel 101 is capable of passing. However, when the temperature sensor 2600 is mounted in a manner shown in FIG. 11A or FIG. 12A, a hole may not be required in the connector connection board 35.

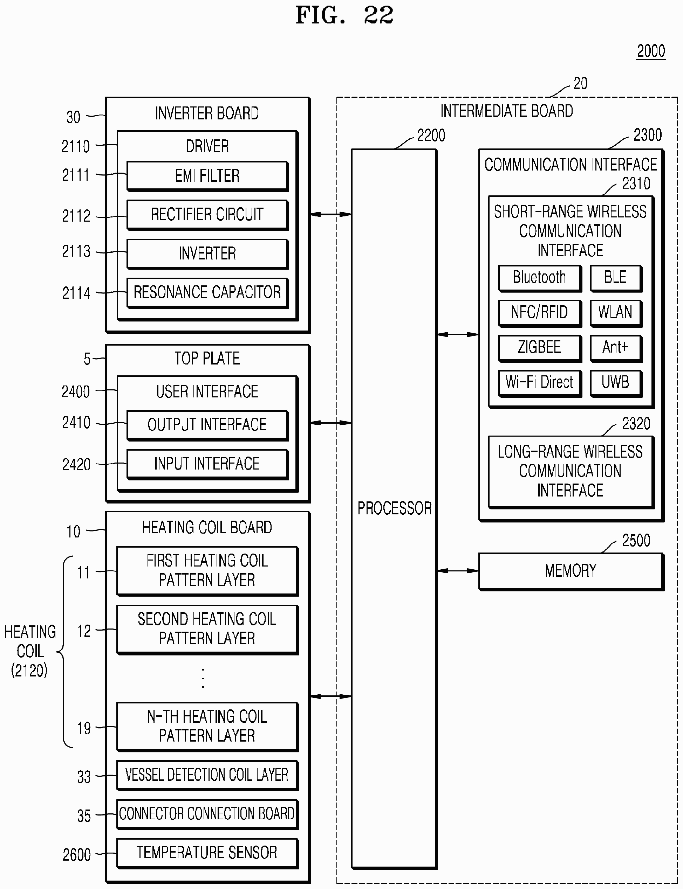

FIG. 22 is a block diagram of an induction heating device according to an embodiment of the present disclosure.

As illustrated in FIG. 22, the induction heating device 2000 according to an embodiment of the present disclosure may include the top plate 5, the heating coil board 10, the intermediate board 20, and the inverter board 30.

In the induction heating device 2000 according to an embodiment of the present disclosure, the top plate 5 may be a plate on which a cooking vessel 100 is placed and may usually include heat-resistant tempered glass. The top plate 5 may include an output interface 2410 such as a display and an input interface 2420 such as a touch button. According to an embodiment, an actual operation of the output interface 2410 such as a display and the input interface 2420 such as a touch button may be performed under control of the processor 2200 provided in the intermediate board 20 described below. According to an embodiment, the display panel or the actual touch button itself may be mounted on the intermediate board 20 and only the interface may be mounted on the top plate 5.

A user interface 2400 to be provided in the top plate 5 may include the output interface 2410 and the input interface 2420. The output interface 2410 is for outputting an audio signal or a video signal and may include a display and an audio output unit.

When the display and the touchpad constitute a touch screen in a layered structure, the display may be used as the input interface 2420 in addition to the output interface 2410. The display may include at least one of a liquid crystal display, a thin film transistor-liquid crystal display, a light-emitting diode (LED), an organic light-emitting diode, a flexible display, a 3D display, or an electrophoretic display. Depending on the design, the induction heating device 2000 may include two or more displays.

The audio output unit may output audio data received from the communication interface 2300 or stored in the memory 2500. The audio output unit may output an audio signal related to a function performed in the induction heating device 2000. The audio output unit may include a speaker and a buzzer.

According to another embodiment of the present disclosure, the output interface 2410 may display information about the cooking vessel 101. For example, the output interface 2410 may output a graphical user interface (GUI) corresponding to identification information or product type information of the cooking vessel 101. The output interface 2410 may output information about the current location of the cooking vessel 101 or the material of the cooking vessel 101.

The input interface 2420 is for receiving input from a user. The input interface 2420 may include at least one of a key pad, a dome switch, a touch pad (contact electrostatic capacitance type, pressure resistive film type, infrared detection type, surface ultrasonic conduction type, integral tension measurement type, piezo effect type, and the like), a jog wheel, or a jog switch, but is not limited thereto.

The input interface 2420 may include a voice recognition module. For example, the induction heating device 2000 may receive a voice signal, which is an analog signal, through a microphone, and convert a voice portion into computer-readable text by using an automatic speech recognition (ASR) model. The induction heating device 2000 may obtain speech intention of the user by interpreting the converted text by using a natural language understanding (NLU) model. Here, the ASR model or NLU model may be an artificial intelligence (AI) model. The AI model may be processed by AI-specific processors designed with a hardware structure specialized for processing an AI model. The AI model may be generated through learning. Here, generating through learning means that a basic AI model is learned using a learning algorithm by using a large number of learning data, thereby generating a predefined operation rule or AI set to perform a desired characteristic (or purpose). The AI model may include a plurality of neural network layers. Each of the plurality of neural network layers has a plurality of weight values, and performs a neural network operation through an operation between the operation results of a previous layer and a plurality of weight values.

Linguistic understanding is the technology of recognizing, applying, and processing human language/characters, including natural language processing, machine translation, dialog systems, question answering, and speech recognition/synthesis.

In the induction heating device 2000 according to an embodiment of the present disclosure, the heating coil board 10 may include the heating coil 2120 that is printed and patterned on the first heating coil pattern layer 11. The heating coil board 10 may have a structure in which a plurality of heating coil pattern layers are stacked. The heating coil 2120 may include a plurality of heating coils, and the plurality of heating coil pattern layers may include the first heating coil pattern layer 11, the second heating coil pattern layer 12, ..., and an n-th heating coil pattern layer 19 (n is a natural number greater than or equal to 2, and n = 4, 8, 12, and 16). The heating coil board 10 may include the connector connection board 35 on which a connector is to be vertically mounted to be connected to the intermediate board 20 and/or the inverter board 30 without wires.

The heating coil 2120 patterned on the heating coil board 10 may generate a magnetic field for heating the cooking vessel 101. For example, when current is supplied to the heating coil 2120, a magnetic field may be induced around the heating coil 2120. When a current with a magnitude and direction that change over time, i.e. an alternating current (AC), is supplied to the heating coil 2120, a magnetic field with a magnitude and direction that change over time may be induced around the heating coil 2120. The magnetic field around the heating coil 2120 may pass through the top plate 5 including tempered glass and reach the cooking vessel 101 placed on the top plate 5. Due to the magnetic field, the magnitude and direction of which change over time, an eddy current that rotates around the magnetic field may be generated in the cooking vessel 101, and the eddy current may cause resistance heat to be generated in the cooking vessel 101. Resistance heat is heat generated in a resistor when current flows through the resistor, and is also called Joule heat. The cooking vessel 101 is heated by electric resistance heat, and the contents inside the cooking vessel 101 may be heated.

In the induction heating device 2000 according to an embodiment of the present disclosure, the heating coil board 10 may further include the temperature sensor 2600. The temperature sensor 2600 may sense the temperature of the top plate 5 or the cooking vessel 101 placed on the top plate 5. The processor 2200 may determine whether empty heating is performed on the cooking vessel 101 or the cooking vessel 101 is overheated based on the temperature of the cooking vessel 101 sensed by the temperature sensor 2600. According to an embodiment, the temperature sensor 2600 may be installed in a hole formed to pass through the heating coil board 10.

Depending on a method of mounting the temperature sensor 2600 on the heating coil board 10, the induction heating device 2000 may further include connectors 160 and 170.

In the induction heating device 2000 according to an embodiment of the present disclosure, the heating coil board 10 may further include the vessel detection coil layer 33. According to an embodiment, the vessel detection coil layer 33 may include the vessel detection coil. According to an embodiment, the vessel detection coil may be printed in a pattern shape on the first heating coil pattern layer 11. The processor 2200 of the induction heating device 2000 may detect whether the cooking vessel 101 is placed on the top plate 5 of the induction heating device 2000 through the vessel detection coil provided in the vessel detection coil layer 33 or the first heating coil pattern layer 11.

The inverter board 30 may include a driver 2110. The driver 2110 may receive power from an input power source and may supply current to the heating coil 2120 according to a driving control signal of the processor 2200. The driver 2110 may include, but is not limited to, an electro magnetic interference (EMI) filter 2111, a rectifier circuit 2112, an inverter 2113, and a resonance capacitor 2114. According to an embodiment, the resonance capacitor 2114 may be located on the intermediate board 20 rather than the inverter board 30 depending on design specifications.

The EMI filter 2111 may block high-frequency noise provided in the AC voltage supplied from the input power source and may pass AC voltage and AC current of a predefined frequency (e.g., 50 Hz or 60 Hz). A fuse and a relay may be provided between the EMI filter 2111 and the input power source to block overcurrent. The AC voltage with high-frequency noise blocked by the EMI filter 2111 is supplied to the rectifier circuit 2112.

The rectifier circuit 2112 may convert an AC voltage into a DC voltage. For example, the rectifier circuit 2112 may convert an AC voltage with a magnitude and polarity (positive voltage or negative voltage) that change over time into a DC current voltage with a magnitude and polarity that are constant, and may convert an AC current with a magnitude and direction (positive current or negative current) that change over time into a DC with a polarity that does not change over time. The rectifier circuit 2112 may include a diode as a rectifying device. For example, the rectifier circuit 2112 may include four diodes. A diode may convert an AC voltage with polarity that changes over time into a positive voltage with polarity that is constant, and an AC current with a direction that changes over time into a positive current with a direction that is constant. The rectifier circuit 2112 may be connected to a DC link capacitor that smooths the rectified DC voltage.

The inverter 2113 may include a switching circuit that supplies or cuts off driving current to the heating coil 2120. The inverter 2113 may generate resonance between the heating coil 2120 and the resonance capacitor 2114 through a switching operation of the switching circuit. According to an embodiment, the resonance capacitor 2114 may be provided in the inverter board 30 or may be provided in the intermediate board 20. The switching circuit may include two switches for each burner as illustrated in FIG. 3. A first switch 2113_1 and a second switch 2113_2 illustrated in FIG. 3 may be turned on or off according to a driving control signal of the processor 2200. According to an embodiment, the induction heating device 2000 may include a separate drive processor in addition to the processor 2200 to generate the driving control signal.

The inverter 2113 may control the current supplied to the heating coil 2120. For example, the magnitude and direction of the current flowing in the first heating coil 2120_1 may change depending on the turning on/off of the first switch 2113_1 and the second switch 2113_2 provided in the inverter 2113. The magnitude and direction of the current flowing in the second heating coil 2120_2 may change depending on the turning on/off of another switch pair provided in the inverter 2113. In this case, an AC current may be supplied to the first heating coil 2120_1 and the second heating coil 2120_2.

The inverter board 30 may include a connector (not shown) that is to be connected between the intermediate board 20 and a board.

In the induction heating device 2000 according to an embodiment of the present disclosure, the intermediate board 20 may be located between the heating coil board 10 and the inverter board 30. The intermediate board 20 may be a first board when the inverter board 30 is a second board. According to an embodiment, the intermediate board 20 may include, but is not limited to, the processor 2200, the communication interface 2300, and the memory 2500. For example, the intermediate board 20 may further include the resonance capacitor 2114. The components provided in the intermediate board 20 may be electrically connected to the components provided in the inverter board 30 through the connector of the inverter board 30.

According to an embodiment, the intermediate board 20 may include the resonance capacitor 2114. This is merely one example, and the resonance capacitor 2114 may be provided in the inverter board 30 depending on the design specifications. The resonance capacitor 2114 may resonate with the heating coil 2120 through switching of the inverter 2113 to induce an eddy current in the cooking vessel 101 placed on the top plate 5 of the induction heating device 2000. As shown in FIG. 3, when there are the plurality of heating coils 2120, the resonance capacitor 2114 may be provided in a plural number to correspond to the heating coils 2120.

The processor 2200 of the intermediate board 20 may determine a switching frequency (turn-on/turn-off frequency) of the switching circuit provided in the inverter 2113 based on an output strength (power level) of the induction heating device 2000. The processor 2200 may generate a driving control signal to turn on/off the switching circuit according to the determined switching frequency. The induction heating device 2000 may include a separate driving processor from the processor 2200 to control the operation of the driver 2110 including the inverter 2113 during the operation of the processor 2200. However, this is merely one example, and the operation of the driving processor may be replaced by the processor 2200.

The processor 2200 controls the overall operation of the induction heating device 2000.

The processor 2200 is a hardware device that controls the overall operation of the induction heating device 2000. The processor 2200 may include one processor or may include a plurality of processors. The processor 2200 according to an embodiment of the present disclosure may include a hardware processing circuit including at least one of a central processing unit (CPU), a graphics processing unit (GPU), an accelerated processing unit (APU), a many integrated core (MIC), a digital signal processor (DSP), an integrated circuit, or a neural processing unit (NPU). The processor 2200 may be implemented in the form of an integrated system on a chip (SoC) including one or more electronic components. When the processor 2200 includes a plurality of processors, each processor may be implemented as a separate hardware (H/W). The processor 2200 may also be expressed as a microprocessor controller (MICOM), a micro processor unit (MPU), or a micro controller unit (MCU). The processor 2200 according to an embodiment of the present disclosure is a hardware device that may be implemented as a single core processor or a multicore processor. The processor 2200 may execute programs stored in the memory 2500 to control the driver 2110, the communication interface 2300, the user interface 2400, and the memory 2500.

According to an embodiment of the present disclosure, the induction heating device 2000 may be equipped with an artificial intelligence (AI) processor. The AI processor may be manufactured in the form of a dedicated hardware chip for AI, or may be manufactured as a portion of an existing general-purpose processor (e.g., CPU or application processor) or a graphics-only processor (e.g., GPU) and mounted on the induction heating device 2000.

The processor 2200 may establish a short-range wireless communication channel (e.g., a BLE communication channel) with the cooking vessel 101 through the communication interface 2300 when the unique identification information of the cooking vessel 101 is stored in the memory 2500.

The communication interface 2300 of the intermediate board 20 may include one or more components that enable communication between the induction heating device 2000 and the cooking vessel 101, the induction heating device 2000 and a server (not shown), or the induction heating device 2000 and a user terminal (not shown). For example, the communication interface 2300 may include a short-range wireless communication interface 2310 and a long-range wireless communication interface 2320. The short-range wireless communication interface 2310 may include, but is not limited to, a Bluetooth communication unit, a Bluetooth low energy (BLE) communication unit, a near field communication interface, a Wi-Fi communication unit, a WLAN communication unit, a Zigbee communication unit, an Infrared Data Association (IrDA) communication unit, a Wi-Fi direct (WFD) communication unit, an ultra wide band (UWB) communication unit, and an Ant+ communication unit. The long-range wireless communication interface 2320 may be used to communicate with a server (not shown) when the cooking vessel 101 is remotely controlled by the server in an Internet of Things (IoT) environment. The long-range wireless communication interface 2320 may include the Internet, a computer network (e.g., LAN or WAN), and a mobile communication unit. The mobile communication unit transmits and receives a wireless signal with at least one of a base station, an external terminal, or a server on a mobile communication network. Here, the wireless signal may include various forms of data such as a voice call signal, a video call signal, or text/multimedia message transmission and reception. The mobile communication unit may include, but is not limited to, a 3G module, a 4G module, an LTE module, a 5G module, a 6G module, an NB-IoT module, and an LTE-M module.

The memory 2500 may store a program for the operation and control of the induction heating device 2000 of the processor 2200, and may store input/output data (e.g., unique identification information of the cooking vessel 101, variable identification information of the cooking vessel 101, a plurality of power transmission patterns, cooking progress information of the cooking vessel 101, and material information of the cooking vessel 101). The memory 2500 may store a coded command regarding a switching operation for driving the inverter 2113. The memory 2500 may store an AI model.

The memory 2500 may include at least one type of storage medium of flash memory type, a hard disk type, a multimedia card micro type, card type memory (e.g., SD or XD memory), random access memory (RAM), static random access memory (SRAM), read-only memory (ROM), electrically erasable programmable read-only memory (EEPROM), programmable read-only memory (PROM), magnetic memory, a magnetic disk, or an optical disk. The induction heating device 2000 may operate a web storage or a cloud server that performs a storage function on the Internet.

According to an embodiment of the present disclosure, an induction heating device including a temperature sensor is disclosed. According to an embodiment, an induction heating device including a temperature sensor may include a plurality of heating coil pattern layers on which a top plate heating coil, on which a cooking vessel is placed, is printed and patterned, and a heating coil board generated by hot-pressing a stack board including an insulating layer that insulates and bonds between heating coil pattern layers among the plurality of heating coil pattern layers. According to an embodiment, an induction heating device including a temperature sensor may include a temperature sensor provided in a hole formed to pass through a heating coil board and configured to detect the temperature of a top plate or a cooking vessel placed on the top plate. According to an embodiment, the temperature sensor may have two leads soldered to at least a portion of the heating coil board without wires.

According to an embodiment of the present disclosure, soldering two leads of the temperature sensor to at least a portion of the heating coil board may include soldering two leads of the temperature sensor to holes provided in at least one board of the heating coil board.

According to an embodiment of the present disclosure, soldering two leads of the temperature sensor to at least a portion of the heating coil board may include soldering two leads of the temperature sensor onto at least one board of the heating coil board.

According to an embodiment of the present disclosure, at least one board of the heating coil board to which two leads of the temperature sensor are soldered may be the lowermost board of the heating coil board.

According to an embodiment of the present disclosure, two leads of the temperature sensor may be soldered on the lowermost board of the heating coil board.

An induction heating device according to an embodiment of the present disclosure may further include an inverter board connected to a heating coil board by a connector, and in this case, the lowermost board of the heating coil board, to which two leads of a temperature sensor are soldered, may include a connector connection board for connecting to the inverter board by a connector.

According to an embodiment of the present disclosure, the lowermost board of the heating coil board may be a board without a hole through which a temperature sensor is provided.

According to an embodiment of the present disclosure, the insulating layer has a thickness less than or equal to 140 µm after hot pressing, and when the stack board is hot pressed, conductors of the plurality of heating coil pattern layers do not come into contact with the reinforced fibers of the insulating layer, and thus insulation may be maintained.

According to an embodiment of the present disclosure, the insulating layer may include 60 % to 80 % of the resin content of the total components.

According to an embodiment of the present disclosure, the insulating layer may be formed by stacking at least two prepreg insulating layers.

According to an embodiment of the present disclosure, the stack board may further include a patterned vessel detection coil layer having a plurality of vessel detection coils printed thereon for detecting a cooking vessel.

According to an embodiment of the present disclosure, each of first ends of the plurality of vessel detection coils may be connected to the lowermost layer of the heating coil board through a via hole. According to an embodiment, a second end of each of the plurality of vessel detection coils may be connected to a connector terminal on the vessel detection coil layer.

An induction heating device according to an embodiment of the present disclosure may further include at least one processor that controls to reduce output through a heating coil provided in a heating coil board when the temperature of a top plate or a cooking vessel detected by a temperature sensor exceeds a certain threshold temperature.

According to an embodiment of the present disclosure, an induction heating device including a temperature sensor is disclosed. According to an embodiment, an induction heating device including a temperature sensor may include a top plate on which a cooking vessel is placed, a plurality of heating coil pattern layers on which the top plate heating coil, on which a cooking vessel is placed, is printed and patterned, and a heating coil board generated by hot-pressing a stack board including an insulating layer that insulates and bonds between heating coil pattern layers among the plurality of heating coil pattern layers. According to an embodiment, an induction heating device including a temperature sensor may include a temperature sensor provided in a hole provided in a heating coil board and configured to detect the temperature of a top plate or a cooking vessel placed on the top plate. According to an embodiment, the temperature sensor may be electrically connected to a female connector with two leads soldered to at least one board of the heating coil board without wires.

According to an embodiment of the present disclosure, the hole provided in the heating coil board may be a hole formed to pass through the heating coil board.

According to an embodiment of the present disclosure, the female connector may be mounted vertically on a lower portion of at least one board of the heating coil boards.

According to an embodiment of the present disclosure, the female connector may be vertically mounted on a lower portion of at least one board of the heating coil board by surface mount technology (SMT).

According to an embodiment of the present disclosure, the female connector may be mounted vertically on an upper portion of at least one board of the heating coil boards.

According to an embodiment of the present disclosure, the female connector may be vertically mounted on an upper portion of at least one board of the heating coil board by surface mount technology (SMT).

According to an embodiment of the present disclosure, the induction heating device may further include an inverter board connected to the heating coil board by a connector. According to an embodiment, at least one board of the heating coil board to which the female connector is soldered may include a connector connection board for connection to the inverter board by the connector.

A method according to an embodiment of the present disclosure may be implemented in the form of program commands that may be executed through various computer devices and recorded in a computer-readable medium. The computer-readable medium may include a program command, a data file, and a data structure alone or in combination. The program commands recorded in the medium may be those specifically designed and configured for the present disclosure or may be known and available to those of skill in the art of computer software. Examples of a computer readable recording medium include magnetic media such as hard disks, floppy disks and magnetic tapes, optical media such as CD-ROMs and DVDs, magneto-optical media such as floptical disks, or hardware devices such as ROMs, RAMs and flash memories, which are specially configured to store and execute program commands. Examples of the program commands include a machine language code generated by a compiler and a high-level language code executable by a computer using an interpreter and the like.

Some embodiments of the present disclosure may also be implemented in the form of a recording medium containing computer-executable instructions, such as program modules executed by a computer. Computer-readable media may be any available media that are to be accessed by a computer, and includes both volatile and nonvolatile media, removable and non-removable media. Computer-readable media may include both computer storage media and communication media. Computer storage media includes both volatile and nonvolatile, removable and non-removable media implemented in any method or technology for storage of information such as computer-readable instructions, data structures, program modules or other data. Communication media typically include computer readable instructions, data structures, program modules, or other data in a modulated data signal such as a carrier wave, or other transport mechanism, and includes any information delivery media. Some embodiments of the present disclosure may also be implemented as a computer program or computer program product including computer-executable instructions, such as a computer program executed by a computer.

The device-readable storage medium may be provided in the form of a non-transitory storage medium. Here, the term 'non-transitory storage medium' simply means a tangible device that does not contain signals (e.g. electromagnetic waves), and the term does not distinguish between cases in which data is stored semi-permanently or temporarily on a storage medium. For example, the 'non-transitory storage medium' may include a buffer in which data is temporarily stored.

According to an embodiment, the methods according to various embodiments disclosed in the document may be provided as provided in a computer program product. The computer program product may be traded between sellers and buyers as commodities. The computer program product may be distributed in the form of a device-readable storage medium (e.g., a compact disc read only memory (CD-ROM)), or may be distributed online (e.g., by download or upload) via an application store or directly between two user devices (e.g., smartphones). In the case of online distribution, at least a portion of the computer program product (e.g., a downloadable app) may be temporarily stored or temporarily generated in a device-readable storage medium, such as the memory of a server of a manufacturer, a server of an application store, or an intermediary server.

## Claims

1. An induction heating device comprising:
a top plate on which a cooking vessel is placed;
a plurality of heating coil pattern layers on which a heating coil is printed and patterned;
a heating coil board generated by hot-pressing a stack board including an insulating layer that insulates and bonds each heating coil pattern layer among the plurality of heating coil pattern layers; and
a temperature sensor provided in a hole formed to pass through the heating coil board and configured to detect a temperature of the top plate or the cooking vessel placed on the top plate,
wherein, in the temperature sensor, two leads are soldered to at least a portion of the heating coil board without wires.

2. The induction heating device of claim 1, wherein the soldering of the two leads of the temperature sensor to at least the portion of the heating coil board comprises soldering of the two leads of the temperature sensor to a hole provided in at least one board of the heating coil board.

3. The induction heating device of claim 1, wherein the soldering of the two leads of the temperature sensor to at least the portion of the heating coil board comprises soldering of the two leads of the temperature sensor to at least one board of the heating coil board.

4. The induction heating device of claim 3, wherein the at least one board of the heating coil board to which the two leads of the temperature sensor are soldered is a lowermost board of the heating coil board.

5. The induction heating device of claim 4, wherein the two leads of the temperature sensor are soldered on the lowermost board of the heating coil board.

6. The induction heating device of claim 4, further comprising an inverter board connected to the heating coil board by a connector,
wherein the lowermost board of the heating coil board, to which the two leads of the temperature sensor are soldered, includes a connector connection board for connection to the inverter board by a connector.

7. The induction heating device of any one of claims 4 to 6, wherein the lowermost board of the heating coil board is a board without a hole through which the temperature sensor passes to be installed.

8. The induction heating device of any one of claims 1 to 7, wherein the insulating layer has a thickness less than or equal to 140 um after hot pressing, and insulation is maintained by not allowing conductors of the plurality of heating coil pattern layers to come into contact with a reinforced fiber of the insulating layer when the stack board is hot pressed.

9. The induction heating device of any one of claims 1 to 8, wherein the insulating layer includes 60 % to 80 % of resin content of total components.

10. The induction heating device of any one of claims 1 to 9, wherein the insulating layer is generated by stacking at least two prepreg insulating layers.

11. The induction heating device of any one of claims 1 to 10, further comprising at least one processor configured to perform control to reduce output through a heating coil provided in the heating coil board when a temperature of the top plate or the cooking vessel detected by the temperature sensor exceeds a certain threshold temperature.

12. An induction heating device comprising:
a top plate on which a cooking vessel is placed;
a plurality of heating coil pattern layers on which a heating coil is printed and patterned;
a heating coil board generated by hot-pressing a stack board including an insulating layer that insulates and bonds each heating coil pattern layer among the plurality of heating coil pattern layers; and
a temperature sensor provided in a hole provided in the heating coil board and configured to detect a temperature of the top plate or the cooking vessel placed on the top plate,
wherein the temperature sensor is electrically connected to a female connector having two leads soldered to at least one board of the heating coil board without wires.

13. The induction heating device of claim 12, wherein the female connector is vertically mounted on a lower portion of at least one of the heating coil boards by surface mount technology (SMT).

14. The induction heating device of claim 12, wherein the female connector is vertically mounted on an upper portion of at least one of the heating coil boards by surface mount technology (SMT).

15. The induction heating device of claim 12, further comprising an inverter board connected to the heating coil board by a connector,
wherein at least one of the heating coil boards to which the female connector is soldered includes a connector connection board for connection to the inverter board by a connector.
